# EUROPEAN PATENT APPLICATION

(11) **EP 4 571 843 A1**
(43) Date of publication of application: **18.06.2025**
(21) Application number: 24185526.1
(22) Date of filing: 28.06.2024
(51) Int. Cl.: H01L 29/778, H01L 21/337, H01L 29/10, H01L 29/207, H01L 29/36, H01L 29/417, H01L 29/20

(54) **SEMICONDUCTOR DEVICE**

(30) Priority: 15.12.2023 KR 20230183430
(71) Applicant: Samsung Electronics Co., Ltd., Suwon-si, Gyeonggi-do 16677 (KR)
(72) Inventor: YANG, Jungseung, Suwon-si (KR); KIM, Boram, Suwon-si (KR); KIM, Jongseob, Suwon-si (KR); PARK, Young Hwan, Suwon-si (KR); SEO, Jonguk, Suwon-si (KR); LEE, Sangjun, Suwon-si (KR); CHOI, Yongseok, Suwon-si (KR)
(74) Representative: Marks & Clerk LLP

(57) **Abstract**

A semiconductor device includes a superlattice layer (124), a high-resistance layer (126) on the superlattice layer and doped with a first material and a second material different from the first material, a channel layer (132) on the high-resistance layer, a barrier layer (136) on the channel layer and including a material having an energy band gap different from that of the channel layer, a gate electrode (155) on the barrier layer, a gate semiconductor layer (152) between the barrier layer and the gate electrode, and a source electrode (173) and a drain electrode (175) positioned on respective sides of the gate electrode and connected to the channel layer. The high-resistance layer (126) includes a first region in which a concentration of the second material is constant, and a second region, on the first region, in which a concentration of the second material decreases in a direction away from a lower surface of the high-resistance layer.

## Description

### BACKGROUND

### 1. Field

Embodiments of the present disclosure relate to a semiconductor device.

### 2. Description of Related Art

In modern society, semiconductor devices are closely related to daily life. Particularly, the importance of power semiconductor devices used in various fields such as transportation fields such as electric vehicles, railroads, and electric trams; renewable energy systems such as solar power generation and wind power generation; and mobile devices is gradually increasing. Power semiconductor devices are semiconductor devices used to handle high voltage and/or high current, and perform functions such as power conversion and control in large power systems or high-output electronic devices. Power semiconductor devices have the ability and durability to handle high power, so they may handle large amounts of current and withstand high voltage. For example, power semiconductor devices may handle voltages from hundreds of volts to thousands of volts and currents from tens of amperes to thousands of amperes. Power semiconductor devices may improve the efficiency of electrical energy by minimizing power loss. Additionally, power semiconductor devices may be stably driven even in environments including high temperatures.

These power semiconductor devices may be classified according to materials, and examples include SiC power semiconductor devices and GaN power semiconductor devices. By manufacturing electric power semiconductor devices using SiC or GaN instead of existing silicon wafers (Si wafer), it is possible to compensate for the disadvantage of silicon, which has unstable characteristics at high temperatures. SiC power semiconductor devices are resistant to high temperatures and have low power loss, and may be suitable for electric vehicles, renewable energy systems, etc. GaN power semiconductor devices require high costs, but are efficient in terms of speed and may be suitable for high-speed charging of mobile devices.

### SUMMARY

According to embodiments of the present disclosure, a semiconductor device with stable electrical characteristics and improved reliability is provided.

According to embodiments of the present disclosure, a semiconductor device is provided and includes: a superlattice layer; a high-resistance layer on the superlattice layer and doped with a first material and a second material different from the first material; a channel layer on the high-resistance layer; a barrier layer on the channel layer and including a material having an energy band gap different from an energy band gap of the channel layer; a gate electrode on the barrier layer; a gate semiconductor layer between the barrier layer and the gate electrode; a source electrode on a first side of the gate electrode and connected to the channel layer; and a drain electrode on a second side of the gate electrode, opposite of the first side, and connected to the channel layer, wherein the high-resistance layer includes: a first region in which a concentration of the second material is constant; and a second region, on the first region, in which a concentration of the second material in the second region decreases in a direction away from a lower surface of the high-resistance layer, toward an upper surface of the high-resistance layer.

According to embodiments of the present disclosure, a semiconductor device is provided and includes: a superlattice layer; a high-resistance layer on the superlattice layer and doped with a first material and a second material different from the first material; a channel layer on the high-resistance layer; a barrier layer on the channel layer and including a material having an energy band gap different from an energy band gap of the channel layer; a gate electrode on the barrier layer; a gate semiconductor layer between the barrier layer and the gate electrode; a source electrode on a first side of the gate electrode and connected to the channel layer; and a drain electrode on a second side of the gate electrode, opposite of the first side, and connected to the channel layer, wherein the high-resistance layer includes: a first region in which a concentration of the second material is constant; a second region, between the first region and the channel layer, in which a concentration of the second material decreases in a direction away from the lower surface of the high-resistance layer, towards an upper surface of the high-resistance layer; and a third region in which a concentration of the second material increases in the direction away from the lower surface of the high-resistance layer, and wherein a concentration of the first material doped in the second region increases in the direction away from the lower surface of the high-resistance layer increases.

According to embodiments of the present disclosure, a semiconductor device is provided and includes: a substrate; a superlattice layer on the substrate, the superlattice layer includes layers including AlGaN and layers including AIN that are alternately stacked and doped with a first material and a second material different from the first material; a high-resistance layer on the superlattice layer and including GaN doped with the first material and the second material; a channel layer on the high-resistance layer and including GaN; a barrier layer on the channel layer and including AlGaN; a gate electrode on the barrier layer and including a metal material; a gate semiconductor layer between the barrier layer and the gate electrode and including GaN doped with a p-type impurity; a source electrode on a first side of the gate electrode, and on a first side surface of the channel layer and a first side surface of the barrier layer; and a drain electrode on a second side of the gate electrode, opposite of the first side, and on a second side surface of the channel layer and a second side surface of the barrier layer; wherein the high-resistance layer includes: a first region in which a concentration of the second material is constant; a second region, between the first region and the channel layer, in which a concentration of the second material decreases in a direction away from the lower surface of the high-resistance layer, towards an upper surface of the high-resistance layer; and a third region, between the first region and the superlattice layer, in which a concentration of the second material increases in the direction away from the lower surface of the high-resistance layer, and wherein the superlattice layer includes: a fourth region in which a concentration of the second material increases in a direction away from a lower surface of the superlattice layer, towards an upper surface of the superlattice layer; and a fifth region between the first region and the high-resistance layer and having a constant concentration of the second material.

According to embodiments of the present disclosure, it is possible to improve the electrical characteristics and reliability of semiconductor devices.

At least some of the above and other features of the invention are set out in the claims.

### BRIEF DESCRIPTION OF DRAWINGS

FIGS. 1 and 2 are cross-sectional views showing a semiconductor device according to an embodiment.
FIG. 3 is an enlarged cross-sectional view of a region A1 of FIG. 1.
FIGS. 4 and 5 are graphs showing the concentration of impurity doped in a buffer layer of a semiconductor device according to an embodiment.
FIGS. 6 to 11 are graphs showing a concentration of impurity doped in a buffer layer of a semiconductor device according to some embodiments.
FIGS. 12 and 13 are cross-sectional views corresponding to the region A1 of FIG. 1, illustrating a buffer layer of a semiconductor device according to some embodiments.
FIGS. 14 and 15 are cross-sectional views showing a process sequence for manufacturing a semiconductor device according to an embodiment.
FIG. 16 is an enlarged cross-sectional view of a region A2 of FIG. 15.
FIGS. 17 to 22 are cross-sectional views showing a process sequence for manufacturing a semiconductor device according to an embodiment.

### DETAILED DESCRIPTION

Non-limiting example embodiments of the present disclosure will be described in detail hereinafter with reference to the accompanying drawings, in which example embodiments of the present disclosure are shown. As those skilled in the art would realize, the described embodiments may be modified in various different ways, all without departing from the scope of the present disclosure.

The drawings and description are to be regarded as illustrative in nature and not restrictive. Like reference numerals designate like elements throughout the specification.

Size and thickness of each constituent element in the drawings may be arbitrarily illustrated for better understanding and ease of description, and embodiments of the present disclosure are not limited thereto. In the drawings, the thickness of layers, films, panels, regions, etc., may be exaggerated for clarity. In the drawings, the thickness of some layers and regions may be exaggerated for ease of description.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is referred to as being "on" or "above" a reference element, it can be positioned above or below the reference element, and it is not necessarily referred to as being positioned "on" or "above" in a direction opposite to gravity. It will further be understood that directional terms, such as "above", below", "horizontal", "vertical" and so on, refer to directions relative to a device, and do not imply any particular orientation of such a device.

In addition, unless explicitly described to the contrary, the word "comprise" (or "include"), and variations such as "comprises" (or "includes") or "comprising" (or "including"), will be understood to imply the inclusion of stated elements but not the exclusion of any other elements.

In addition, the phrase "on a plane" means a view from a position above the object (e.g., from the top), and the phrase "on a cross-section" means a view of a cross-section of the object which is vertically cut from the side.

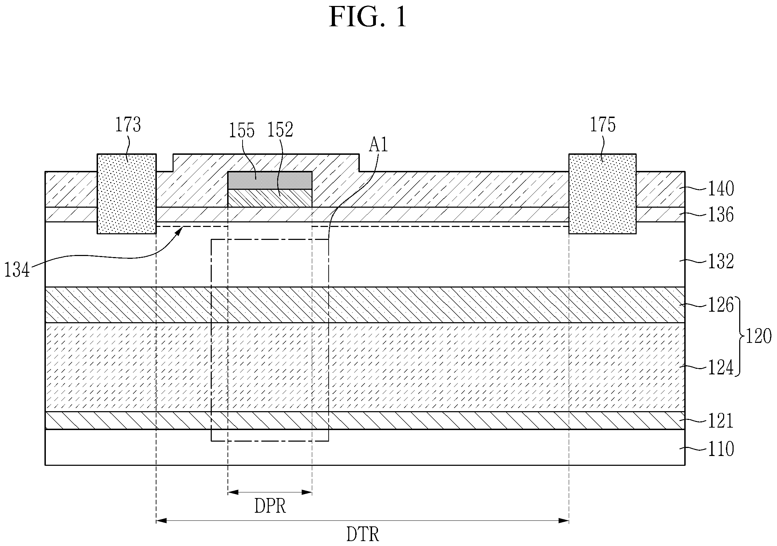

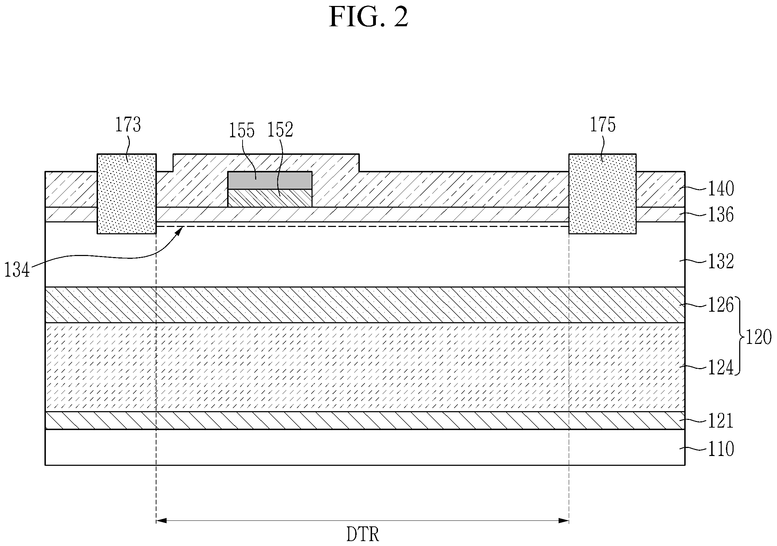

Hereinafter, a semiconductor device according to an embodiment will be described with reference to FIGS. 1 and 2 as follows.

FIGS. 1 and 2 are cross-sectional views showing a semiconductor device according to an embodiment. FIG. 1 shows a case in which a semiconductor device according to an embodiment is in an off state, and FIG. 2 shows a case in which a semiconductor device according to an embodiment is in an on state.

As shown in FIG. 1, a semiconductor device according to an embodiment may include a channel layer 132, a barrier layer 136 positioned on the channel layer 132, a gate electrode 155 positioned on the barrier layer 136, a gate semiconductor layer 152 positioned between the barrier layer 136 and the gate electrode 155, a protective layer 140 positioned on the barrier layer 136, and a source electrode 173 and a drain electrode 175 spaced apart from each other on the channel layer 132.

The channel layer 132 is a layer that forms a channel between the source electrode 173 and the drain electrode 175, and a two-dimensional electron gas (2DEG) 134 may be positioned inside the channel layer 132. The two-dimensional electron gas 134 is a charge transport model used in solid physics, which refers to a group of electrons that may move freely in two-dimensions (e.g., in an x-y plane direction, which may be directions within a horizontal plane with reference to the drawings), but are firmly confined within the two-dimensions and cannot move in another dimension (e.g., in a z direction, which may be a vertical direction with reference to the drawings).

In other words, the two-dimensional electron gas 134 may exist in a two-dimensional paper-like form within a three-dimensional space. This two-dimensional electron gas 134 mainly appears in a semiconductor heterojunction structure, and may occur at the interface between the channel layer 132 and the barrier layer 136 in a semiconductor device according to an embodiment. For example, the two-dimensional electron gas 134 may be generated in a portion of the channel layer 132 adjacent to the barrier layer 136.

The channel layer 132 may include one or more materials selected from group III-V materials, for example, nitrides containing Al, Ga, In, B, or a combination thereof. The channel layer 132 may be made of a single layer or multiple layers. The channel layer 132 may be AlₓIn_{y}Ga_{1-x-y}N (0≤x≤1, 0≤y≤1, x+y≤1). For example, the channel layer 132 may include AIN, GaN, InN, InGaN, AlGaN, AlInN, AlInGaN, or a combination thereof. The channel layer 132 may be a layer doped with impurities or a layer undoped with impurities. The thickness of the channel layer 132 may be about several hundred nm or less.

The channel layer 132 may be positioned on a substrate 110, and a seed layer 121 and a buffer layer 120 may be positioned between the substrate 110 and the channel layer 132. The substrate 110, seed layer 121, and buffer layer 120 are layers for forming the channel layer 132, and may be omitted in some cases. For example, when a substrate made of GaN is used as the channel layer 132, at least one from among the substrate 110, the seed layer 121, and the buffer layer 120 may be omitted. Considering that the price of a substrate made of GaN is relatively high, the channel layer 132 including GaN may be grown using the substrate 110 made of Si. In such case, as the lattice structure of Si and GaN are different, it may not be easy to grow the channel layer 132 directly on the substrate 110. Accordingly, the seed layer 121 and the buffer layer 120 may first be grown on the substrate 110, and then the channel layer 132 may be grown on the buffer layer 120. Additionally, at least one from among the substrate 110, the seed layer 121, and the buffer layer 120 may be removed from the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited thereto, and any commonly used substrate may be applied. In some cases, the substrate 110 may include an insulating material. For example, several layers, including the channel layer 132, may be first formed on a semiconductor substrate, and then the semiconductor substrate may be removed and replaced with an insulating substrate.

The seed layer 121 may be positioned directly on the substrate 110. However, embodiments are not limited thereto, and another predetermined layer may be further positioned between the substrate 110 and the seed layer 121. The seed layer 121 is a layer that serves as a seed for growing the buffer layer 120, and may be made of a crystal lattice structure that serves as a seed for the buffer layer 120. The buffer layer 120 may be positioned directly on the seed layer 121. However, embodiments are not limited thereto, and another predetermined layer may be further positioned between the seed layer 121 and the buffer layer 120. The seed layer 121 may include one or more materials selected from group III-V materials, for example, nitrides containing Al, Ga, In, B, or a combination thereof. The seed layer 121 may be AlₓIn_{y}Ga_{1-x-y}N (0≤x≤1, 0≤y≤1, x+y≤1). For example, the seed layer 122 may include AlN, GaN, InN, InGaN, AlGaN, AlInN, AlInGaN, or a combination thereof.

The buffer layer 120 may be positioned on the seed layer 121. The buffer layer 120 may be positioned between the seed layer 121 and the channel layer 132. The buffer layer 120 may be a layer to alleviate the difference in lattice constant and thermal expansion coefficient between the seed layer 121 and the channel layer 132 or to prevent parasitic current (leakage current) from flowing through the channel layer 132. The buffer layer 120 may include one or more materials selected from group III-V materials, for example, nitrides containing Al, Ga, In, B, or a combination thereof. The buffer layer 120 may be AlₓIn_{y}Ga_{1-x-y}N (0≤x≤1, 0≤y≤1, x+y≤1). For example, the buffer layer 120 may include AlN, GaN, InN, InGaN, AlGaN, AlInN, AlInGaN, or a combination thereof.

The buffer layer 120 of the semiconductor device according to an embodiment may include a superlattice layer 124 positioned on the seed layer 121, and a high-resistance layer 126 positioned on the superlattice layer 124. The superlattice layer 124 and the high-resistance layer 126 may be sequentially positioned on the substrate 110.

The superlattice layer 124 may be positioned on the seed layer 121. The superlattice layer 124 may be positioned directly on the seed layer 121. However, embodiments are not limited thereto, and another predetermined layer may be further positioned between the seed layer 121 and the superlattice layer 124. The superlattice layer 124 is a layer for alleviating the difference in lattice constant and thermal expansion coefficient between the substrate 110 and the channel layer 132, thereby alleviating a tensile stress and compressive stress generated between the substrate 110 and the channel layer 132, and alleviating stress between all layers formed by growth in the final structure of a semiconductor device according to an embodiment. The superlattice layer 124 may include one or more materials selected from group III-V materials, for example, nitrides containing Al, Ga, In, B, or a combination thereof. The superlattice layer 124 may be AlₓIn_{y}Ga_{1-x-y}N (0≤x≤1, 0≤y≤1, x+y≤1). For example, the superlattice layer 124 may include AlN, GaN, InN, InGaN, AlGaN, AlInN, AlInGaN, or a combination thereof.

In an embodiment, the superlattice layer 124 may be made of multiple layers in which layers containing different materials are alternately stacked. For example, the superlattice layer 124 may have a structure in which a layer made of AlGaN and a layer made of AlN are repeatedly stacked. That is, AlGaN/AlN/AlGaN/AlN/AlGaN/AlN may be sequentially stacked to form a superlattice layer. The number of AlGaN layers and GaN included in the superlattice layer 124 may vary, and the material included in the superlattice layer 124 may vary. As another example, the superlattice layer 124 may have a structure in which a layer made of AlGaN and a layer made of GaN are repeatedly stacked. That is, AlGaN/GaN/AlGaN/GaN/AlGaN/GaN may be sequentially stacked to form a superlattice layer. In an embodiment, when the superlattice layer 124 includes GaN, InN, AlGaN, AlInN, InGaN, AlN, AlInGaN, or a combination thereof, the superlattice layer 124 may have larger n-type semiconductor characteristics where the concentration of electrons is greater than the concentration of holes, but is not limited thereto.

In an embodiment, the superlattice layer 124 may be doped with impurities. For example, the superlattice layer 124 may be doped with a first material and a second material different from the first material. Here, the first material may include carbon (C), and the second material may include magnesium (Mg), iron (Fe), or a combination thereof. Here, the first material and the second material may act as an acceptor within the superlattice layer 124 having n-type characteristics.

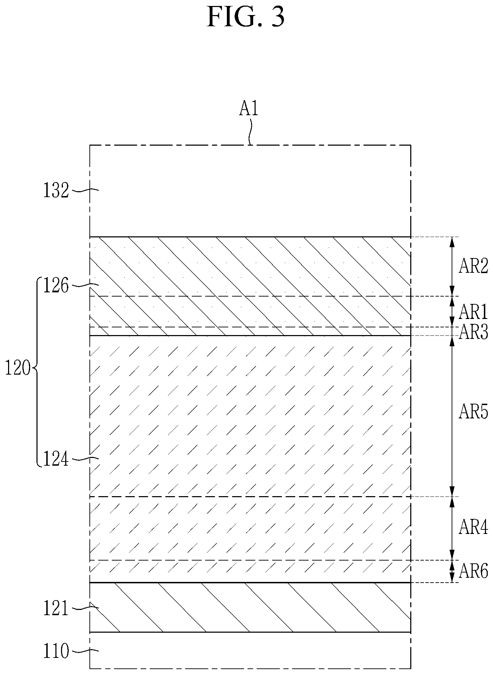

In such cases, the superlattice layer 124 may include a region where the doping concentrations of the first material and the second material are different. For example, the superlattice layer 124 may include a region where the concentration of the second material is constant and a region where the concentration of the second material increases as the distance from the lower surface of the superlattice layer 124 increases. Alternatively, the superlattice layer 124 may include a region where the concentration of the first material is constant and a region where the concentration of the first material decreases as the distance from the lower surface of the superlattice layer 124 increases. For example, the superlattice layer 124 may include a sixth region AR6 (see FIG. 3) where the concentration of the second material is constant, a fourth region AR4 (see FIG. 3) where the concentration of the second material increases as the distance from the lower surface of the superlattice layer 124 increases, and a fifth region AR5 (see FIG. 3) where the concentration of the second material is constant. A description of this will be provided later with reference to FIGS. 3 to 5.

The high-resistance layer 126 may be positioned on the superlattice layer 124. The high-resistance layer 126 may be positioned directly on the superlattice layer 124. However, embodiments are not limited thereto, and another predetermined layer may be further positioned between the superlattice layer 124 and the high-resistance layer 126. The high-resistance layer 126 may be positioned between the superlattice layer 124 and the channel layer 132. The high-resistance layer 126 is a layer for preventing deterioration of the semiconductor device according to an embodiment by preventing leakage current from flowing through the channel layer 132. The high-resistance layer 126 may be made of a low-conductivity material to electrically insulate the substrate 110 and the channel layer 132. For example, the high-resistance layer 126 may be an insulation layer. The high-resistance layer may include one or more materials selected from group III-V materials, such as nitrides containing Al, Ga, In, B, or combinations thereof. The high-resistance layer 126 may be AlₓIn_{y}Ga_{1-x-y}N (0≤x≤1, 0≤y≤1, x+y≤1). For example, the high-resistance layer 126 may include AlN, GaN, InN, InGaN, AlGaN, AlInN, AlInGaN, or a combination thereof. The high-resistance layer 126 may be made of a single layer or multiple layers. In an embodiment, when the superlattice layer 124 includes GaN, InN, AlGaN, AlInN, InGaN, AlN, AlInGaN, or a combination thereof, the high-resistance layer 126 may have larger n-type semiconductor characteristics where the concentration of electrons is greater than the concentration of holes, but is not limited thereto.

In an embodiment, impurities may be doped in the high-resistance layer 126. The impurities doped in the high-resistance layer 126 may include the same material as the material of the impurities doped in the superlattice layer 124. For example, the high-resistance layer 126 may be doped with a first material and a second material different from the first material. Here, the first material may include carbon (C), and the second material may include magnesium (Mg), iron (Fe), or a combination thereof. Here, the first material and the second material may function as an acceptor within the high-resistance layer 126 having n-type characteristics.

In such case, the high-resistance layer 126 may include a region where the doping concentrations of the first material and the second material are different. For example, the high-resistance layer 126 may include a region where the concentration of the second material is constant, a region where the concentration of the second material increases as the distance from the lower surface of the high-resistance layer 126 increases, and a region where the concentration of the second material decreases as the distance from the lower surface of the high-resistance layer 126 increases. Alternatively, the high-resistance layer 126 may include a region where the concentration of the first material is constant, a region where the concentration of the first material increases as the distance from the lower surface of the high-resistance layer 126 increases, and a region where the concentration of the first material decreases as the distance from the lower surface of the high-resistance layer 126 increases. For example, the high-resistance layer 126 may include a third region AR3 (see FIG. 3) where the concentration of the second material increases as the distance from the lower surface of the high-resistance layer 126 increases, a first region AR1 (see FIG. 3) where the concentration of the second material is constant, and a second region AR2 (see FIG. 3) where the concentration of the first material decreases as the distance from the lower surface of the high-resistance layer 126 increases. A description of this will be provided later with reference to FIGS. 3 to 5.

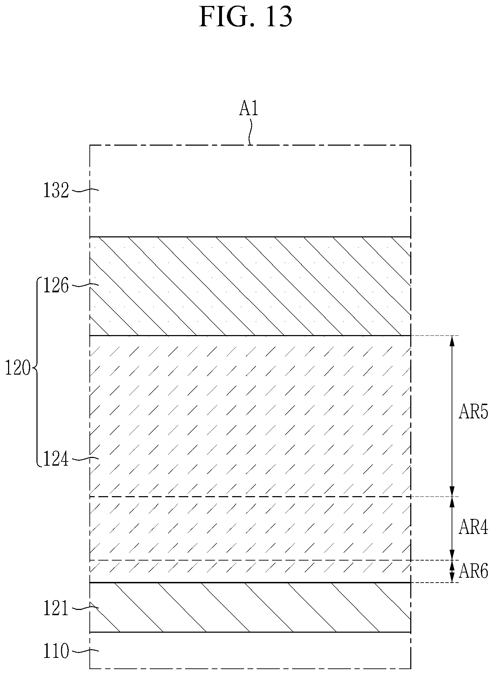

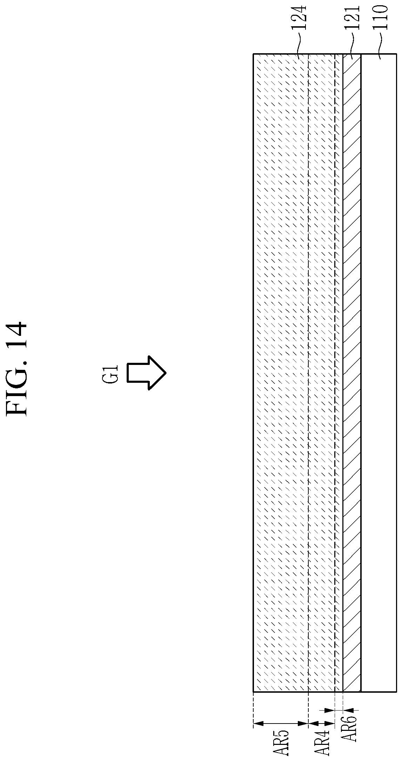

In an embodiment, the superlattice layer 124 and the high-resistance layer 126 may include a first material and a second material, respectively, but are not limited thereto. For example, one of the superlattice layer 124 and the high-resistance layer 126 may include the first material and the second material, and the other layer may not include the second material. A description of this will be provided later with reference to FIGS. 13 and 14.

The barrier layer 136 may be positioned on the channel layer 132. The barrier layer 136 may be positioned directly on the channel layer 132. However, embodiments are not limited thereto, and another predetermined layer may be further positioned between the channel layer 132 and the barrier layer 136. An area of the channel layer 132 that overlaps the barrier layer 136 may be a drift region DTR. The drift region DTR may be positioned between the source electrode 173 and the drain electrode 175. The drift region DTR may refer to a region where carriers move when a potential difference occurs between the source electrode 173 and the drain electrode 175.

The semiconductor device according to an embodiment may be turned on/off depending on whether a voltage is applied to the gate electrode 155 and/or the magnitude of the voltage applied to the gate electrode 155, and accordingly, movement of the carrier may be achieved or blocked in the drift region DTR.

The barrier layer 136 may include one or more materials selected from group III-V materials, for example, nitrides containing Al, Ga, In, B, or a combination thereof. The barrier layer 136 may be AlₓIn_{y}Ga_{1-x-y}N (0≤x≤1, 0≤y≤1, x+y≤1). The barrier layer 136 may include GaN, InN, AlGaN, AlInN, InGaN, AlN, AlInGaN, or a combination thereof. The energy band gap of the barrier layer 136 may be adjusted by the composition ratio of Al and/or In. The barrier layer 136 may be doped with a predetermined impurity. In such case, the impurity doped into the barrier layer 136 may be a p-type dopant that may provide holes. For example, the impurity doped into the barrier layer 136 may be magnesium (Mg). By increasing or decreasing the impurity doping concentration of the barrier layer 136, the threshold voltage, on-resistance, etc. of the semiconductor device according to an embodiment may be adjusted.

The barrier layer 136 may include a semiconductor material having different characteristics from the channel layer 132. The barrier layer 136 may be different from the channel layer 132 in at least one from among polarization characteristics, energy band gap, and lattice constant. For example, the barrier layer 136 may include a material having a different energy band gap than the channel layer 132. In such case, the barrier layer 136 may have a higher energy band gap than the channel layer 132, and may have a higher electrical polarization rate than the channel layer 132. The two-dimensional electron gas 134 may be induced in the channel layer 132 having a relatively low electrical polarization rate by the barrier layer 136. In this regard, the barrier layer 136 may also be referred to as a channel supply layer or a two-dimensional electron gas supply layer. The two-dimensional electron gas 134 may be formed within the portion of the channel layer 132 positioned below the interface between the channel layer 132 and the barrier layer 136. The two-dimensional electron gas 134 may have very high electron mobility.

The barrier layer 136 may be made of a single layer or multiple layers. When the barrier layer 136 is made of multiple layers, the materials of each layer included in the multiple layers may have different energy band gaps. In such case, the various layers included in the barrier layer 136 may be arranged so that the energy band gap increases as the layers approach the channel layer 132.

The gate electrode 155 may be positioned on the barrier layer 136. The gate electrode 155 may overlap a portion of the barrier layer 136 in a vertical direction (e.g., the thickness direction of the channel layer 132). The gate electrode 155 may overlap a portion of the drift region DTR of the channel layer 132 in a vertical direction (e.g., the thickness direction of the channel layer 132). The gate electrode 155 may be positioned between the source electrode 173 and the drain electrode 175. The gate electrode 155 may be spaced apart from the source electrode 173 and the drain electrode 175. For example, the gate electrode 155 may be positioned closer to the source electrode 173 than the drain electrode 175. That is, the separation distance between the gate electrode 155 and the source electrode 173 may be less than the separation distance between the gate electrode 155 and the drain electrode 175, but is not limited thereto.

The gate electrode 155 may include a conductive material. For example, the gate electrode 155 may include metal, metal alloy, conductive metal nitride, metal silicide, doped semiconductor material, conductive metal oxide, or conductive metal nitride. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but are not limited thereto. The gate electrode 155 may be made of a single layer or multiple layers.

The gate semiconductor layer 152 may be positioned between the barrier layer 136 and the gate electrode 155. That is, the gate semiconductor layer 152 may be positioned on the barrier layer 136, and the gate electrode 155 may be positioned on the gate semiconductor layer 152. The gate electrode 155 may be in Schottky contact or ohmic contact with the gate semiconductor layer 152. The gate semiconductor layer 152 may overlap with the gate electrode 155 in a vertical direction (e.g., the thickness direction of the channel layer 132). In such case, the gate semiconductor layer 152 may be completely overlapped in a vertical direction (e.g., in the thickness direction of the channel layer 132) with the gate electrode 155, and the upper surface of the gate semiconductor layer 152 may be entirely covered by the gate electrode 155.

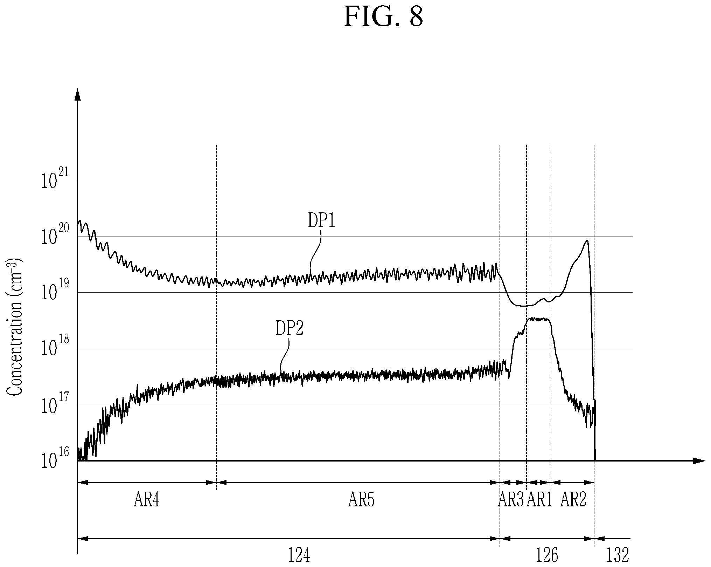

That is, the gate semiconductor layer 152 may have substantially the same planar shape as a planar shape of the gate electrode 155. However, embodiments are not limited thereto, and the gate electrode 155 may be positioned to partially cover at least a portion of the gate semiconductor layer 152. A description of this will be provided later with reference to FIG. 8.

The gate semiconductor layer 152 may be positioned between the source electrode 173 and the drain electrode 175. The gate semiconductor layer 152 may be spaced apart from the source electrode 173 and the drain electrode 175. The gate semiconductor layer 152 may be positioned closer to the source electrode 173 than the drain electrode 175. That is, the separation distance between the gate semiconductor layer 152 and the source electrode 173 may be less than the separation distance between the gate semiconductor layer 152 and the drain electrode 175, but is not limited thereto.

In an embodiment, the gate semiconductor layer 152 may overlap with the gate electrode 155 in a vertical direction (e.g., the thickness direction of the channel layer 132). For example, the gate semiconductor layer 152 may completely overlap the gate electrode 155 in a vertical direction (e.g., the thickness direction of the channel layer 132). That is, the side surface of the gate semiconductor layer 152 may be aligned with the side surface of the gate electrode 155. However, embodiments are not limited thereto, and the gate semiconductor layer 152 may partially overlap the gate electrode 155.

The gate semiconductor layer 152 may include one or more materials selected from group III-V materials, for example, nitrides containing Al, Ga, In, B, or a combination thereof. The gate semiconductor layer 152 may be AlₓIn_{y}Ga_{1-x-y}N (0≤x≤1, 0≤y≤1, x+y≤1). For example, the gate semiconductor layer 152 may include AlN, GaN, InN, InGaN, AlGaN, AlInN, AlInGaN, or a combination thereof. The gate semiconductor layer 152 may include a material having an energy band gap different from that of the barrier layer 136. For example, the gate semiconductor layer 152 may include GaN, and the barrier layer 136 may include AlGaN. The gate semiconductor layer 152 may be doped with a predetermined impurity. In such case, the impurity doped into the gate semiconductor layer 152 may be a p-type dopant that may provide holes. For example, the gate semiconductor layer 152 may include GaN doped with p-type impurities. That is, the gate semiconductor layer 152 may be made of a p-GaN layer. However, embodiments are not limited thereto, and the gate semiconductor layer 152 may be a p-AlGaN layer. The impurity doped into the gate semiconductor layer 152 may be magnesium (Mg). In such case, when a predetermined element adjacent to the impurity (e.g., magnesium) doped in the gate semiconductor layer 152 combines, the hole concentration in the gate semiconductor layer 152 may be reduced, thereby deteriorating the characteristics of the semiconductor device. The gate semiconductor layer 152 may be made of a single layer or multiple layers.

A depletion region DPR may be formed in the channel layer 132 by the gate semiconductor layer 152. The depletion region DPR may be positioned within the drift region DTR and may have a narrower width than a width of the drift region DTR. As the gate semiconductor layer 152 having an energy band gap different from that of the barrier layer 136 is positioned on the barrier layer 136, the level of the energy band of the portion of the barrier layer 136 that overlaps with the gate semiconductor layer 152 may increase. Accordingly, the depletion region DPR may be formed in the region of the channel layer 132 that overlaps with the gate semiconductor layer 152. The depletion region DPR may be a region in the channel path of the channel layer 132 where the two-dimensional electron gas 134 is not formed or may have a lower electron concentration than the remaining regions. That is, the depletion region DPR may mean a region where the flow of the two-dimensional electron gas 134 is interrupted within the drift region DTR. As the depletion region DPR occurs, current does not flow between the source electrode 173 and the drain electrode 175, and the channel path may be blocked. Accordingly, the semiconductor device according to an embodiment may have normally-off characteristics.

That is, the semiconductor device according to an embodiment may be a normally-off high electron mobility transistor (HEMT). As shown in FIG. 1, in a normal state in which no voltage is applied to the gate electrode 155, the depletion region DPR exists, and the semiconductor device according to an embodiment may be in an off state. As shown in FIG. 2, when a voltage greater than the threshold voltage is applied to the gate electrode 155, the depletion region DPR disappears, and the two-dimensional electron gas 134 within the drift region DTR may be continuously connected without being interrupted.

That is, the two-dimensional electron gas 134 may be formed throughout the channel path between the source electrode 173 and the drain electrode 175, and the semiconductor device according to an embodiment may be in an on state. In summary, the semiconductor device according to an embodiment may include semiconductor layers with different electrical polarization characteristics, and a semiconductor layer with a relatively large polarization may induce the two-dimensional electron gas 134 to another semiconductor layer which is heterogeneously junctioned therewith. This two-dimensional electron gas 134 may be used as a channel between the source electrode 173 and the drain electrode 175, and the flow or interruption of this two-dimensional electron gas 134 may be controlled by the bias voltage applied to the gate electrode 155. In the gate-off state, the flow of the two-dimensional electron gas 134 is blocked, so current may not flow between the source electrode 173 and the drain electrode 175. As the two-dimensional electron gas 134 continues to flow in the gate-on state, current may flow between the source electrode 173 and the drain electrode 175.

Although the case where the semiconductor device according to an embodiment is a normally-off high electron mobility transistor has been described above, embodiments of the present disclosure are not limited thereto. For example, the semiconductor device according to an embodiment may be a normally-on high electron mobility transistor. In the case of the normally-on high electron mobility transistor, the gate semiconductor layer 152 may be omitted, and thus the gate electrode 155 may be positioned directly on the barrier layer 136. That is, the gate electrode 155 may contact the barrier layer 136. In this structure, the two-dimensional electron gas 134 may be used as a channel while no voltage is applied to the gate electrode 155, and current flow may occur between the source electrode 173 and the drain electrode 175. Additionally, when a negative voltage is applied to the gate electrode 155, the depletion region DPR in which the flow of the two-dimensional electron gas 134 is interrupted may occur at the bottom of the gate electrode 155.

The seed layer 121, superlattice layer 124, high-resistance layer 126, channel layer 132, barrier layer 136, and gate semiconductor layer 152 may be sequentially stacked on the substrate 110. In the semiconductor device according to an embodiment, at least one from among the seed layer 121, the superlattice layer 124, the high-resistance layer 126, the channel layer 132, the barrier layer 136, and the gate semiconductor layer 152 may be omitted. The seed layer 121, superlattice layer 124, high-resistance layer 126, channel layer 132, barrier layer 136, and gate semiconductor layer 152 may be made of the same base semiconductor material, and the material composition ratio of each layer may be different, considering the role of each layer and the performance required for the semiconductor device.

The protective layer 140 may be positioned on the barrier layer 136 and the gate electrode 155. The protective layer 140 may cover the upper and side surfaces of the gate electrode 155 and the side surfaces of the gate semiconductor layer 152. The lower surface of the protective layer 140 may be in contact with the barrier layer 136 and the gate electrode 155. Accordingly, the barrier layer 136, the gate semiconductor layer 152, and the gate electrode 155 may be protected by the protective layer 140. However, embodiments are not limited thereto, and the gate electrode 155 may penetrate the protective layer 140 and connect to the gate semiconductor layer 152. Additionally, the protective layer 140 may not cover the upper surface of the gate electrode 155. Alternatively, the lower surface of the protective layer 140 may contact the gate semiconductor layer 152. The protective layer 140 may include an insulating material. For example, the protective layer 140 may include an oxide such as SiO₂ or Al₂O₃. As another example, the protective layer 140 may include a nitride such as SiN or an oxynitride such as SiON.

In FIGS. 1 and 2, the protective layer 140 is shown as being made of a single layer, but embodiments of the present disclosure are not limited thereto, and the protective layer 140 may be made of multiple layers containing different materials.

The source electrode 173 and the drain electrode 175 may be positioned on the channel layer 132. The source electrode 173 and the drain electrode 175 may be in direct contact with the channel layer 132 and may be electrically connected to the channel layer 132. The source electrode 173 and the drain electrode 175 may be spaced apart from each other, and the gate electrode 155 and the gate semiconductor layer 152 may be positioned between the source electrode 173 and the drain electrode 175. The gate electrode 155 and the gate semiconductor layer 152 may be spaced apart from the source electrode 173 and the drain electrode 175. For example, the source electrode 173 may be electrically connected to the channel layer 132 on one side of the gate electrode 155, and the drain electrode 175 may be electrically connected to the channel layer 132 on the other side of the gate electrode 155. The source electrode 173 and the drain electrode 175 may be positioned outside the drift region DTR of the channel layer 132. The interface between the source electrode 173 and the channel layer 132 may be one edge of the drift region DTR. Likewise, the interface between the drain electrode 175 and the channel layer 132 may be the other edge of the drift region DTR.

However, embodiments of the present disclosure are not limited thereto, and the source electrode 173 and the drain electrode 175 may not be positioned outside the drift region DTR of the channel layer 132. In such case, the channel layer 132 may not be recessed, and the source electrode 173 and the drain electrode 175 may be positioned on the upper surface of the channel layer 132. The bottom surfaces of the source electrode 173 and the drain electrode 175 may contact the upper surface of the channel layer 132. A portion of the channel layer 132 in contact with the source electrode 173 and the drain electrode 175 may be doped at a high concentration. In such case, the carrier that has passed through the two-dimensional electron gas 134 may be transmitted to the source electrode 173 and the drain electrode 175 after passing through the portion of the channel layer 132 that is doped at a high concentration, i.e., the upper portion of the two-dimensional electron gas 134. The source electrode 173 and the drain electrode 175 may not directly contact the two-dimensional electron gas 134 in the horizontal direction. Here, the horizontal direction may mean a direction parallel to the upper surface of the channel layer 132 or the barrier layer 136.

Specifically, trenches that penetrate the protective layer 140 and the barrier layer 136 and recess the upper surface of the channel layer 132 may be positioned on both sides of the gate electrode 155 to be spaced apart from each other. The source electrode 173 and the drain electrode 175 may be positioned in the trench positioned on both sides of the gate electrode 155, respectively. The source electrode 173 and the drain electrode 175 may be formed to fill the trenches. In the trenches, the source electrode 173 and the drain electrode 175 may contact the channel layer 132 and the barrier layer 136. The channel layer 132 may form the bottom and side walls of the trenches, and the barrier layer 136 may form the side walls of the trenches. Accordingly, the source electrode 173 and the drain electrode 175 may contact the upper and side surfaces of the channel layer 132. Additionally, the source electrode 173 and the drain electrode 175 may contact the side surface of the barrier layer 136. That is, the source electrode 173 and the drain electrode 175 may cover the side surfaces of the channel layer 132 and the barrier layer 136.

In an embodiment, the source electrode 173 and the drain electrode 175 may cover at least a portion of the side surface of the protective layer 140. For example, the source electrode 173 and the drain electrode 175 may cover the side surface of the protective layer 140. The upper surfaces of the source electrode 173 and the drain electrode 175 may protrude beyond the upper surface of the protective layer 140. Additionally, at least one from among the source electrode 173 and the drain electrode 175 may cover at least a portion of the upper surface of the protective layer 140. However, embodiments of the present disclosure are not limited thereto, and the source electrode 173 and the drain electrode 175 may cover at least a portion of the side surface of the protective layer 140 and may not cover the remaining portion of the side surface of the protective layer 140. In this case, the remaining part of the protective layer 140 may be positioned on the upper surfaces of the source electrode 173 and the drain electrode 175. A description of this will be provided later with reference to FIG. 8.

The source electrode 173 and the drain electrode 175 may include a conductive material. For example, the source electrode 173 and the drain electrode 175 may include metal, metal alloy, conductive metal nitride, metal silicide, doped semiconductor material, conductive metal oxide, or conductive metal nitride. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but are not limited thereto. The source electrode 173 and the drain electrode 175 may be made of a single layer or multiple layers. The source electrode 173 and the drain electrode 175 may be in ohmic contact with the channel layer 132. The region in contact with the source electrode 173 and the drain electrode 175 within the channel layer 132 may be doped at a relatively high concentration compared to other regions of the channel layer 132.

Although FIGS. 1 and 2 show that the semiconductor device according to an embodiment includes a pair of electrodes (e.g., a source electrode 173 and a drain electrode 175), the number of the source electrodes 173 and the drain electrodes 175 is not limited thereto. For example, a plurality of the source electrodes 173 may be sequentially stacked on the channel layer 132 in a vertical direction (e.g., in the thickness direction of the channel layer 132), and a plurality of the drain electrodes 175 may be sequentially stacked on the channel layer 132 in a vertical direction (e.g., in the thickness direction of the channel layer 132). Alternatively, each of the source electrode 173 and the drain electrode 175 may include three or more layers.

According to embodiments, the semiconductor device may further include a field dispersion layer that covers at least a portion of the protective layer 140.

The field dispersion layer may be positioned between the source electrode 173 and the drain electrode 175. The field dispersion layer may cover the gate electrode 155. The field dispersion layer may overlap the gate electrode 155 in a vertical direction (e.g., the thickness direction of the channel layer 132). The field dispersion layer may be electrically connected to the source electrode 173. For example, the field dispersion layer may be connected to the source electrode 173. The field dispersion layer may include the same material as a material of the source electrode 173 and may be positioned in the same layer as the source electrode 173. The field dispersion layer may be formed simultaneously with the source electrode 173 in the same process. That is, the boundary between the field dispersion layer and the source electrode 173 may not be perceivable, and the field dispersion layer may be formed integrally with the source electrode 173. However, embodiments are not limited thereto, and the field dispersion layer may be a separate component from the source electrode 173. Additionally, the field dispersion layer may be positioned in a different layer from the source electrode 173 and may be formed in a different process.

The field dispersion layer may serve to disperse the electric field concentrated around the gate electrode 155. Specifically, in the gate-off state, the portion of the channel layer 132 positioned between the gate electrode 155 and the source electrode 173 and the channel layer 132 positioned between the gate electrode 155 and the drain electrode 175 may have a very high concentration of two-dimensional electron gas 134.

In this case, an electric field may be concentrated on the gate electrode 155 or the gate semiconductor layer 152. Meanwhile, the gate electrode 155 and the gate semiconductor layer 152 are vulnerable to electric fields, so when electric fields are concentrated, leakage current may increase and breakdown voltage may decrease. In such case, the electric field concentrated around the gate electrode 155 or the gate semiconductor layer 152 may be dispersed by the field dispersion layer, so that leakage current may be reduced and breakdown voltage may be increased.

Hereinafter, the buffer layer 120 of the semiconductor device according to an embodiment will be described with further reference to FIGS. 3 to 5.

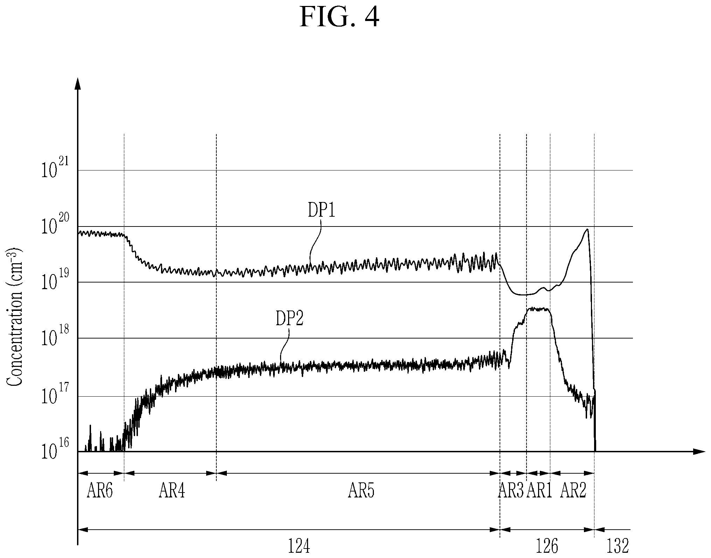

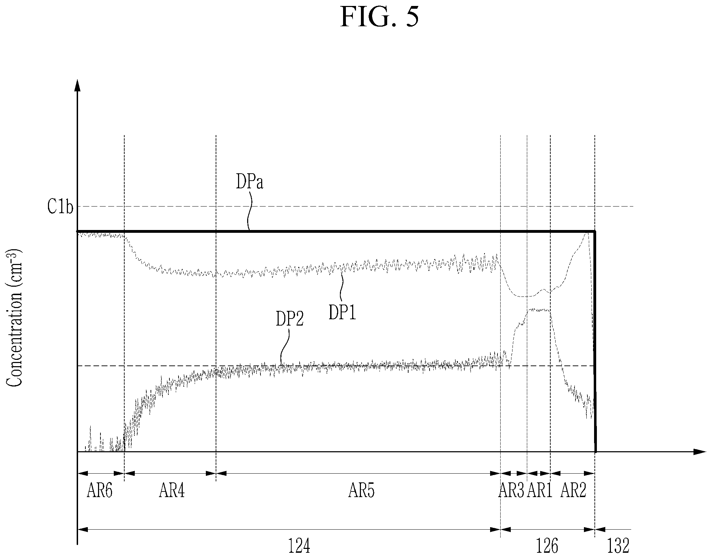

FIG. 3 is an enlarged cross-sectional view of region A1 of FIG. 1. FIGS. 4 and 5 are graphs showing the concentration of impurity doped in the buffer layer of the semiconductor device according to an embodiment. FIG. 4 is a graph showing the concentrations of a first material and a second material doped in the buffer layer of the semiconductor device according to an embodiment. FIG. 5 is a graph showing the total concentration of impurities doped in the buffer layer of the semiconductor device according to an embodiment.

As described above, impurities may be doped into the high-resistance layer 126 and the superlattice layer 124 of the semiconductor device according to an embodiment. The impurities doped in the high-resistance layer 126 may include the same material as the material of the impurities doped in the superlattice layer 124. For example, the high-resistance layer 126 and the superlattice layer 124 may be doped with a first material and a second material different from the first material. Here, the first material may include carbon (C), and the second material may include magnesium (Mg), iron (Fe), or a combination thereof. Relative concentrations of such impurities are now described. One skilled in the art will understand that terms such as "constant", "increasing", "decreasing", and so on, may be interpreted as substantially, approximately, or within manufacturing tolerance constant, increasing, decreasing, etc.

Referring further to FIGS. 3 and 4, the superlattice layer 124 of the semiconductor device according to an embodiment may include regions where the concentration DP2 of the second material doped therein is different. For example, the superlattice layer 124 may include the sixth region AR6 where the concentration of the second material is constant, the fourth region AR4 where the concentration of the second material increases as the distance from the lower surface of the superlattice layer 124 increases, and the fifth region AR5 where the concentration of the second material is constant.

The sixth region AR6 may be positioned on the seed layer 121. For example, the sixth region AR6 may be positioned directly on the upper surface of the seed layer 121. The lower surface of the sixth region AR6 may be in contact with the seed layer 121. The thickness of the sixth region AR6 along the vertical direction (e.g., the thickness direction of the substrate 110) may be 200 nm to 500 nm.

In an embodiment, the concentration DP2 of the second material in the sixth region AR6 may be constant. For example, the concentration DP2 of the second material in the sixth region AR6 may have a smallest value among the concentrations DP2 of the second material in the first to sixth regions AR1 to AR6 but it is not limited thereto. For example, the concentration DP2 of the second material in the sixth region AR6 may be about 10¹⁷cm⁻³, but is not limited thereto.

Additionally, the concentration DP1 of the first material in the sixth region AR6 may be constant, but is not limited thereto. The concentration DP1 of the first material in the sixth region AR6 may be greater than the concentration DP2 of the second material in the sixth region AR6, but is not limited thereto.

The fourth region AR4 may be positioned on the sixth region AR6. For example, the fourth region AR4 may be positioned directly on the sixth region AR6. The fourth region AR4 may be positioned between the sixth region AR6 and the fifth region AR5, which will be described later. The thickness of the fourth region AR4 along the vertical direction (e.g., the thickness direction of the substrate 110) may be 200 nm to 2000 nm.

In an embodiment, the concentration DP2 of the second material in the fourth region AR4 may increase as the distance from the lower surface of the superlattice layer 124 increases. For example, the concentration DP2 of the second material in the fourth region AR4 may gradually increase from the concentration DP2 of the second material in the upper surface of the sixth region AR6 as the distance from the lower surface of the superlattice layer 124 increases. Accordingly, the concentration DP2 of the second material at the interface between the sixth region AR6 and the fourth region AR4 may be less than concentration DP2 of the second material at the interface between the fourth region AR4 and the fifth region AR5. That is, the concentration DP2 of the second material at the lower surface of the superlattice layer 124 may be less than the concentration DP2 of the second material at the interface between the fourth region AR4 and the fifth region AR5. In other words, the concentration DP2 of the second material in the fourth region AR4 may increase as it approaches the channel layer 132.

Additionally, the concentration DP1 of the first material in the fourth region AR4 may decrease as the distance from the lower surface of the superlattice layer 124 increases. For example, the concentration DP1 of the first material in the fourth region AR4 may gradually decrease from the concentration DP1 of the first material in the upper surface of the sixth region AR6 as the distance from the lower surface of the superlattice layer 124 increases. Accordingly, the concentration DP1 of the first material at the interface between the sixth region AR6 and the fourth region AR4 may be greater than the concentration DP1 of the first material at the interface between the fourth region AR4 and the fifth region AR5. That is, the concentration DP1 of the first material at the lower surface of the superlattice layer 124 may be greater than the concentration DP1 of the first material at the interface between the fourth region AR4 and the fifth region AR5. In other words, the concentration DP1 of the first material in the fourth area AR4 may decrease as it approaches the channel layer 132.

The fifth region AR5 may be positioned on the fourth region AR4. For example, the fifth region AR5 may be positioned directly on the fourth region AR4. The fifth region AR5 may be positioned between the fourth region AR4 and the high-resistance layer 126. The fifth region AR5 may contact the lower surface of the high-resistance layer 126.

In an embodiment, the concentration DP2 of the second material in the fifth region AR5 may be substantially constant. The concentration DP2 of the second material in the fifth region AR5 may be greater than the concentration DP2 of the second material in the sixth region AR6. For example, the concentration DP2 of the second material at the interface between the superlattice layer 124 and the high-resistance layer 126 may be greater than the concentration DP2 of the second material at the interface between the superlattice layer 124 and the seed layer 121.

Additionally, the concentration DP1 of the first material in the fifth region AR5 may be substantially constant. The concentration DP1 of the first material in the fifth region AR5 may be less than the concentration DP1 of the first material in the sixth region AR6. For example, the concentration DP1 of the first material at the interface between the superlattice layer 124 and the high-resistance layer 126 may be less than the concentration DP1 of the first material at the interface between the superlattice layer 124 and the seed layer 121. The concentration DP1 of the first material in the sixth region AR5 may be greater than the concentration DP2 of the second material in the fifth region AR5, but is not limited thereto.

In such case, a total concentration DPa of impurities doped in the superlattice layer 124 may be maintained almost constant (e.g. substantially constant). Here, the total concentration DPa of impurities doped in the superlattice layer 124 may mean the sum of the concentrations of impurities doped in the superlattice layer 124. That is, as shown in FIG. 5, the sum of the concentration DP1 of the first material and the concentration DP2 of the second material doped in the fourth to sixth regions AR4 to AR6 of the superlattice layer 124 may be constant. For example, the sum of the concentration DP1 of the first material and the concentration DP2 of the second material doped in the fourth to sixth regions AR4 to AR6 of the superlattice layer 124 may be about 10¹⁷ cm⁻³ to 10²¹ cm⁻³. However, embodiments are not limited thereto, and, for example, as shown in FIG. 5, the total concentration of impurities doped in the superlattice layer 124 may increase as the distance from the lower surface of the superlattice layer 124 increases. However, even in this case, the total concentration of impurities doped in the superlattice layer 124 may be about 10¹⁷ cm⁻³ to about 10²¹ cm⁻³. As another example, the total concentration doped in the superlattice layer 124 may decrease as the distance from the lower surface of the superlattice layer 124 increases. As another example, the superlattice layer 124 may further include a region where the total concentration is different in a predetermined region.

In an embodiment, the high-resistance layer 126 may include regions where the concentration DP2 of the second material doped therein is different. For example, the high-resistance layer 126 may include the third region AR3 where the concentration DP2 of the second material increases as the distance from the lower surface of the high-resistance layer 126 increases, the first region AR1 where the concentration DP2 of the second material is constant, and the second region AR2 where the concentration DP2 of the second material decreases as the distance from the lower surface of the high-resistance layer 126 increases.

The third region AR3 may be positioned on the superlattice layer 124. For example, the third region AR3 may be positioned directly on the upper surface of the superlattice layer 124. The third region AR3 may be positioned between the first region AR1 and the superlattice layer 124. The third region AR3 may be in contact with the upper surface of the superlattice layer 124. The thickness of the third region AR3 in the vertical direction (e.g., the thickness direction of the substrate 110) may be 200 nm to 1000 nm.

In an embodiment, the concentration DP2 of the second material in the third region AR3 may increase as the distance from the lower surface of the high-resistance layer 126 increases. For example, the concentration DP2 of the second material in the third region AR3 may gradually increase from the concentration DP2 of the second material in the upper surface of the fifth region AR5 as the distance from the lower surface of the high-resistance layer 126 increases. Accordingly, the concentration DP2 of the second material at the interface between the fifth region AR5 and the third region AR3 may be less than concentration DP2 of the second material at the interface between the third region AR3 and the first region AR1. That is, the concentration DP2 of the second material at the lower surface of the high-resistance layer 126 may be less than the concentration DP2 of the second material at the interface between the third region AR3 and the first region AR1. In other words, the concentration DP2 of the second material in the third region AR3 may increase as it approaches the channel layer 132.

Additionally, the concentration DP1 of the first material in the third region AR3 may decrease as the distance from the lower surface of the high-resistance layer 126 increases. For example, the concentration DP1 of the first material in the third region AR3 may gradually decrease from the concentration DP1 of the first material in the upper surface of the fifth region AR5 as the distance from the lower surface of the high-resistance layer 126 increases. That is, the concentration DP1 of the first material at the lower surface of the high-resistance layer 126 may be greater than the concentration DP1 of the first material at the interface between the third region AR3 and the first region AR1. In other words, the concentration DP1 of the first material in the third region AR3 may decrease as it approaches the channel layer 132. However, embodiments are not limited thereto, and may further include a section in which the concentration DP1 of the first material in the third region AR3 increases as the distance from the lower surface of the high-resistance layer 126 increases.

The first region AR1 may be positioned on the third region AR3. For example, the first region AR1 may be positioned directly on the third region AR3. The first region AR1 may be positioned between the third region AR3 and the second region AR2.

In an embodiment, the concentration DP2 of the second material in the first region AR1 may be substantially constant. The concentration DP2 of the second material in the first region AR1 may have the maximum value of the concentration DP2 of the second material doped in the high-resistance layer 126. For example, the concentration DP2 of the second material in the first region AR1 may be greater than the concentration DP2 of the second material in the third region AR3. That is, the concentration DP2 of the second material in the first region AR1 may be greater than the concentration DP2 of the second material at the interface between the high-resistance layer 126 and the superlattice layer 124. Additionally, the concentration DP2 of the second material in the first region AR1 may be greater than the concentration DP2 of the second material in the fifth region AR5. This can be due to the process characteristic that the concentration DP2 of the doped second material increases with distance from the lower surface of the high-resistance layer 126 in the third region AR3, which is positioned between the fifth region AR5 and the first region AR1.

For example, the concentration DP2 of the second material in the first region AR1 may be about 10¹⁷cm⁻³ to about 10²¹cm⁻³, but is not limited thereto.

Additionally, the concentration DP1 of the first material in the first region AR1 may be substantially constant. For example, the concentration DP1 of the first material in the first region AR1 may be less than the concentration DP1 of the first material in the fifth region AR5. Additionally, the concentration DP1 of the first material in the first region AR1 may be greater than the concentration DP2 of the second material in the first region AR1, but is not limited thereto.

The second region AR2 may be positioned on the first region AR1. For example, the second region AR2 may be positioned directly on the upper surface of the first region AR1. The second region AR2 may be positioned between the first region AR1 and the channel layer 132. The second region AR2 may contact the lower surface of the channel layer 132. The thickness of the second region AR2 in the vertical direction (e.g., the thickness direction of the substrate 110) may be 200 nm to 1000 nm.

In an embodiment, the concentration DP2 of the second material in the second region AR2 may decrease as the distance from the lower surface of the high-resistance layer 126 increases. For example, the concentration DP2 of the second material in the second region AR2 may gradually decrease from the concentration DP2 of the second material in the upper surface of the third region AR3 as the distance from the lower surface of the high-resistance layer 126 increases. Accordingly, the concentration DP2 of the second material at the interface between the first region AR1 and the second region AR2 may be greater than the concentration DP2 of the second material at the interface between the second region AR2 and the channel layer 132. That is, the concentration DP2 of the second material at the upper surface of the high-resistance layer 126 may be less than the concentration DP2 of the second material at the interface between the first region AR1 and the second region AR2. In other words, the concentration DP2 of the second material in the second region AR2 may decrease as it approaches the channel layer 132.

Additionally, the concentration DP1 of the first material in the second region AR2 may include a portion that increases as the distance from the lower surface of the high-resistance layer 126 increases. For example, the concentration DP1 of the first material in the second region AR2 may gradually increase from the concentration DP1 of the first material in the upper surface of the first region AR1 as the distance from the lower surface of the high-resistance layer 126 increases. Meanwhile, the concentration DP1 of the first material in the second area AR2 adjacent to the channel layer 132 may further include a portion where the concentration DP1 rapidly decreases as the distance from the lower surface of the high-resistance layer 126 increases.

In such case, the total concentration DPa of impurities doped in the high-resistance layer 126 may be constant. Here, the total concentration DPa of impurities doped in the high-resistance layer 126 may mean the sum of the concentrations of impurities doped in the high-resistance layer 126. That is, as shown in FIG. 5, the sum of the concentration DP1 of the first material and the concentration DP2 of the second material doped in the first to third regions AR1 to AR3 of the high-resistance layer 126 may be constant. For example, the sum of the concentration DP1 of the first material and the concentration DP2 of the second material doped in the first to third regions AR1 to AR3 of the high-resistance layer 126 may be about 10¹⁷cm⁻³ to 10²¹cm⁻³. However, embodiments are not limited thereto, and for example, the total concentration doped in the high-resistance layer 126 may increase as the distance from the lower surface of the high-resistance layer 126 increases. However, even in this case, the total concentration of impurities doped in the high-resistance layer 126 may be about 10¹⁷cm⁻³ to about 10²¹cm⁻³. In such case, a maximum value C1b of the total concentration DPa of impurities doped in the high-resistance layer 126 may be about 10¹⁹cm⁻³ to about 10²¹cm⁻³. As another example, the total concentration doped in the high-resistance layer 126 may decrease as the distance from the lower surface of the high-resistance layer 126 increases. As another example, the high-resistance layer 126 may further include a region where the total concentration is different in a predetermined region.

In an embodiment, the total concentration of impurities doped in the high-resistance layer 126 may be substantially the same as the total concentration of impurities doped in the superlattice layer 124, but is not limited thereto. For example, the total concentration of impurities doped in the high-resistance layer 126 may be greater or less than the total concentration of impurities doped in the superlattice layer 124.

In an embodiment, when the superlattice layer 124 and the high-resistance layer 126 include GaN, InN, AlGaN, AlInN, InGaN, AlN, AlInGaN, or a combination thereof, the superlattice layer 124 and the high-resistance layer 126 may have larger n-type semiconductor characteristics where the concentration of electrons is greater than the concentration of holes. In this case, the first material doped in the superlattice layer 124 and the high-resistance layer 126 may provide holes in the superlattice layer 124 and the high-resistance layer 126 to reduce the concentration of electrons in the superlattice layer 124 and the high-resistance layer 126.

That is, the first material may function as an acceptor in the superlattice layer 124 and the high-resistance layer 126 having n-type characteristics. Meanwhile, when the first material is doped at a predetermined concentration or higher, the first material may increase the concentration of electrons in the superlattice layer 124 and the high resistance layer 126 by providing electrons due to the amphoteric effect or self-compensation effect in the superlattice layer 124 and high resistance layer 126. That is, when the first material is doped above a predetermined concentration, the first material may function as a donor and an acceptor in the superlattice layer 124 and the high-resistance layer 126.

The semiconductor device according to an embodiment may be doped with a first material and a second material in the superlattice layer 124 and the high-resistance layer 126. In this case, as the second material is doped with a predetermined concentration, the first material may be doped in a smaller concentration. Accordingly, the amphoteric effect or self-compensation effect caused by the first material in the superlattice layer 124 and the high-resistance layer 126 may be reduced, and the characteristics of the superlattice layer 124 and the high-resistance layer 126 may be improved. That is, the semiconductor device according to an embodiment may have stable electric characteristics, and reliability may be improved.

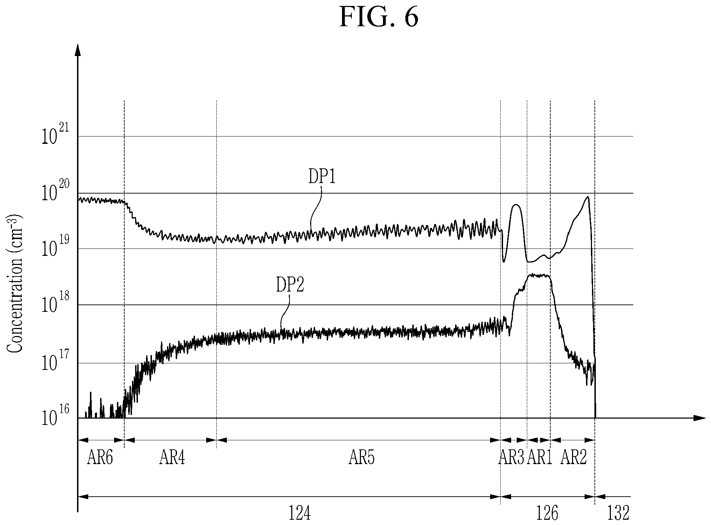

Hereinafter, semiconductor devices according to some embodiments will be described with reference to FIGS. 6 to 13.

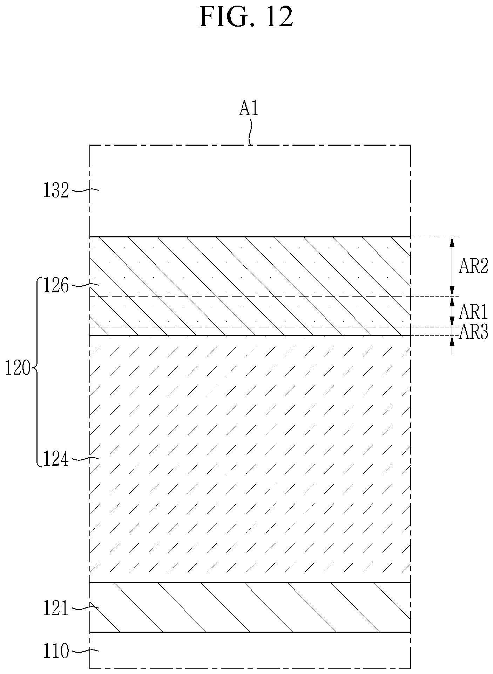

FIGS. 6 to 11 are graphs showing the concentration of impurity doped in the buffer layer of a semiconductor device according to some embodiments. FIGS. 12 and 13 are cross-sectional views corresponding to region A1 of FIG. 1, illustrating a buffer layer of a semiconductor device according to some embodiments.

FIGS. 6 to 14 show numerous variations of the semiconductor device according to an embodiment shown in FIGS. 1 to 5. Since some aspects of the embodiments shown in FIGS. 6 to 14 are substantially the same as aspects of the embodiment shown in FIGS. 1 to 5, description thereof may be omitted and differences between the embodiments will be mainly explained. Additionally, the same reference numerals are used for the same components as those in the previous embodiments. In the embodiments shown in FIGS. 6 to 14, the concentrations of the first material and the second material doped in the superlattice layer 124 and/or the high-resistance layer 126 may differ in some respects from the previous embodiments.

Referring to FIG. 6, the high-resistance layer 126 of the semiconductor device according to some embodiments may include a region where the sum of the concentration DP1 of the first material and the concentration DP2 of the second material is different.

For example, the concentration DP1 of the first material in the third region AR3 may further include a section where the concentration DP1 increases as the distance from the lower surface of the high-resistance layer 126 increases. That is, the concentration DP1 of the first material in the third region AR3 may increase and then decrease. The concentration DP1 of the first material at the center of the third region AR3 may be greater than the concentration DP1 of the first material at the edge of the third region AR3. In such case, the concentration DP1 of the first material in the third region AR3 may be about 10¹⁷cm⁻³ to about 10²¹cm⁻³, but is not limited thereto. Additionally, the concentration DP2 of the second material in the third region AR3 may increase as the distance from the lower surface of the high-resistance layer 126 increases.

Accordingly, the total concentration of impurities doped in the third region AR3 may be greater than the total concentration of impurities doped in the first region AR1 and the second region AR2. Here, the total concentration DPa of impurity may mean the sum of the concentrations of doped impurities. However, even in this case, the total concentration of impurities doped in the third region AR3 may be about 10¹⁷cm⁻³ to to about 10²¹cm⁻³.

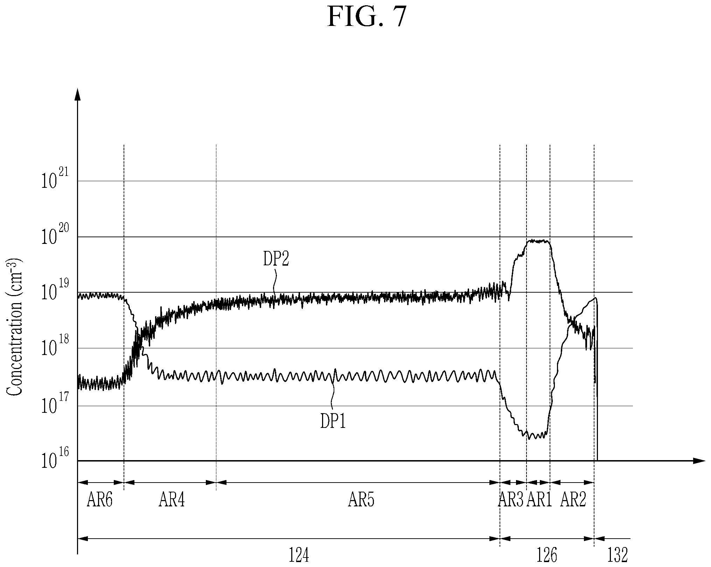

Referring to FIG. 7, the concentration DP2 of the second material in at least one from among the first to sixth regions AR1 to AR6 of the semiconductor device according to some embodiments may be greater than the concentration DP1 of the first material.

In some embodiments, the concentration DP2 of the second material in the fifth region AR5 may be greater than the concentration DP1 of the first material in the fifth region AR5. For example, the concentration DP2 of the second material at the interface between the superlattice layer 124 and the high-resistance layer 126 may be greater than the concentration DP1 of the first material at the interface between the superlattice layer 124 and the high-resistance layer 126, but is not limited thereto. Additionally, the concentration DP2 of the second material in the third region AR3 may be greater than the concentration DP1 of the first material in the third region AR3. For example, the minimum value of the concentration DP2 of the second material in the third region AR3 may be greater than the maximum value of the concentration DP1 of the first material in the third region AR3, but is not limited thereto. Additionally, the concentration DP2 of the second material in the first region AR1 may be greater than the concentration DP1 of the first material in the first region AR1.

Referring to FIG. 8, semiconductor devices according to some embodiments may not include the sixth region AR6.

In some embodiments, the superlattice layer 124 may include the fourth region AR4 positioned on the upper surface of the seed layer 121 and the fifth region AR5 positioned on the fourth region AR4. The fourth region AR4 may be positioned on the upper surface of the seed layer 121. The fourth region AR4 may be positioned between the seed layer 121 and the fifth region AR5. Accordingly, the concentration DP2 of the second material may increase as the distance from the lower surface of the superlattice layer 124 increases and then becomes constant. Additionally, the concentration DP1 of the first material may increase as the distance from the lower surface of the superlattice layer 124 increases and then becomes constant. In such case, the sum of the concentration DP1 of the first material and the concentration DP2 of the second material doped in the superlattice layer 124 may be maintained almost (e.g. substantially) constant, but is not limited thereto.

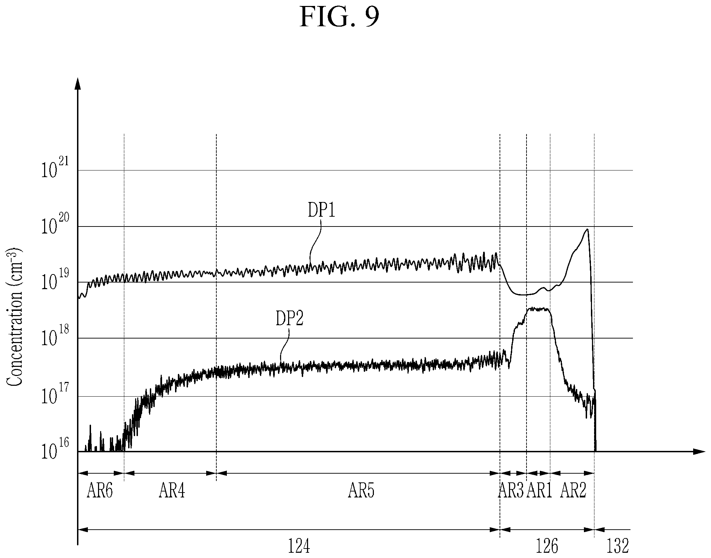

Referring to FIG. 9, the concentration DP1 of the first material doped in at least one from among the fourth to sixth regions AR4 to AR6 of the superlattice layer 124 of the semiconductor device according to some embodiments may increase as the distance from the lower surface of the superlattice layer 124 increases.

For example, as shown in FIG. 9, the concentration DP1 of the first material doped in the fourth to sixth regions AR4 to AR6 of the superlattice layer 124 may increase as the distance from the lower surface of the superlattice layer 124 increases. That is, the concentration DP1 of the first material doped in the sixth region AR6 may increase as the distance from the lower surface of the superlattice layer 124 increases, the concentration DP1 of the first material doped in the fourth region AR4 may increase as the distance from the lower surface of the superlattice layer 124 increases, and the concentration DP1 of the first material doped in the fifth region AR5 may increase as the distance from the lower surface of the superlattice layer 124 increases. In other words, the concentration DP1 of the first material doped in the superlattice layer 124 may gradually increase as the distance from the lower surface of the superlattice layer 124 increases. Accordingly, the concentration DP1 of the first material doped on the lower surface of the superlattice layer 124 may be less than the concentration DP1 of the first material doped on the upper surface of the superlattice layer 124.

In FIG. 9, it is shown that the concentration DP1 of the first material doped in the sixth region AR6 may increase as the distance from the lower surface of the superlattice layer 124 increases, the concentration DP1 of the first material doped in the fourth region AR4 may increase as the distance from the lower surface of the superlattice layer 124 increases, and the concentration DP1 of the first material doped in the fifth region AR5 may increase as the distance from the lower surface of the superlattice layer 124 increases, but is not limited thereto.

For example, the concentration DP1 of the first material doped in the sixth region AR6 may increase as the distance from the lower surface of the superlattice layer 124 increases, and the concentration DP1 of the first material doped in the fourth region AR4 may be maintained almost (e.g. substantially) constant.

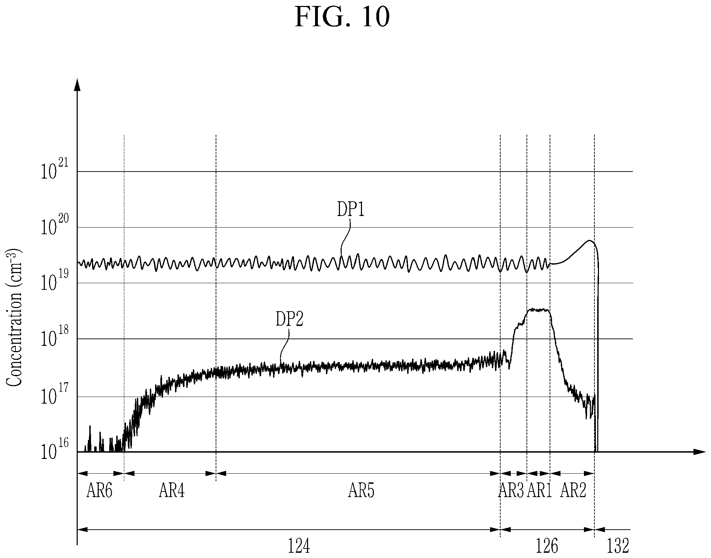

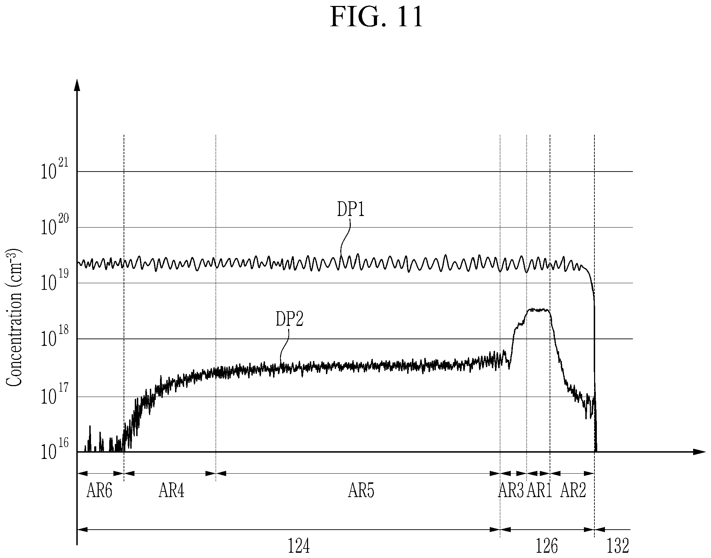

Referring to FIGS. 10 and 11, the concentration DP1 of the first material doped in the superlattice layer 124 and/or the high-resistance layer 126 of the semiconductor device according to some embodiments may be maintained almost (e.g. substantially) constant.

For example, as shown in FIG. 10, the concentration DP1 of the first material doped in the superlattice layer 124 may be maintained almost (e.g. substantially) constant. That is, the concentration DP1 of the first material doped on the lower surface of the superlattice layer 124 may be substantially the same as the concentration DP1 of the first material doped on the upper surface of the superlattice layer 124. In addition, the concentration DP1 of the first material doped in the first region AR1 and the second region AR2 may be substantially same as the concentration DP1 of the first material doped on the upper surface of the superlattice layer 124, but is not limited thereto. As another example, as shown in FIG. 11, the concentration DP1 of the first material doped in the high-resistance layer 126 may be maintained almost (e.g. substantially) constant. That is, the concentration DP1 of the first material doped in the first region AR1 of the high-resistance layer 126 may be maintained almost constant, and the concentration DP1 of the first material doped in the second region AR2 of the high-resistance layer 126 may be maintained almost constant.

Referring to FIGS. 12 and 13, the superlattice layer 124 or the high-resistance layer 126 of the semiconductor device according to some embodiments may not include the second material.

For example, as shown in FIG. 12, the high-resistance layer 126 of a semiconductor device according to some embodiments may be doped with a first material and a second material, and the superlattice layer 124 may be doped with a first material. That is, the high-resistance layer 126 may include the third region AR3 where the concentration of the second material increases as the distance from the lower surface of the high-resistance layer 126 increases, the first region AR1 where the concentration of the second material is constant, and the second region AR2 where the concentration of the second material decreases as the distance from the lower surface of the high-resistance layer 126 increases. In the superlattice layer 124, the second material may not be doped. As another example, as shown in FIG. 13, the superlattice layer 124 of the semiconductor device according to some embodiments may be doped with a first material and a second material, and the high-resistance layer 126 may be doped with a first material. In other words, the superlattice layer 124 may include the sixth region AR6 where the concentration of the second material is constant, the fourth region AR4 where the concentration of the second material increases as the distance from the lower surface of the high-resistance layer 126 increases, and the fifth region AR5 where the concentration of the second material is constant. The second material may not be doped in the high-resistance layer 126.

Hereinafter, a method of manufacturing a semiconductor device according to an embodiment will be described with reference to FIGS. 14 to 22.

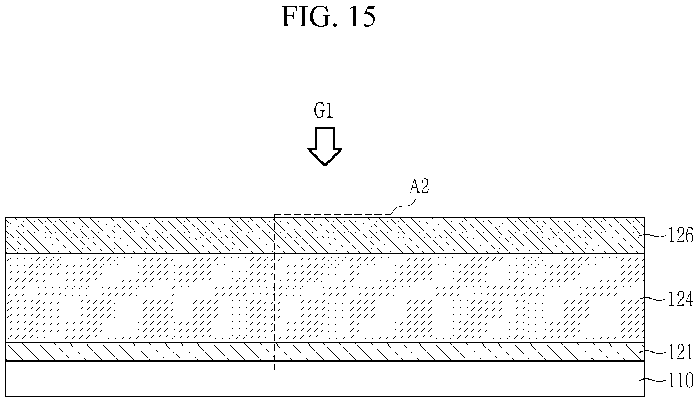

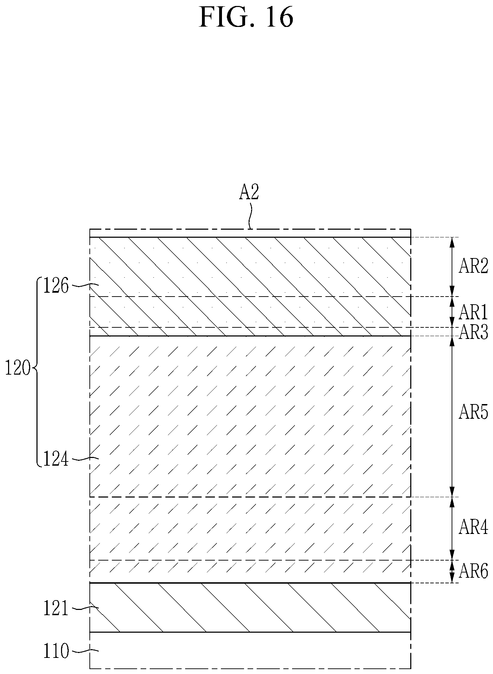

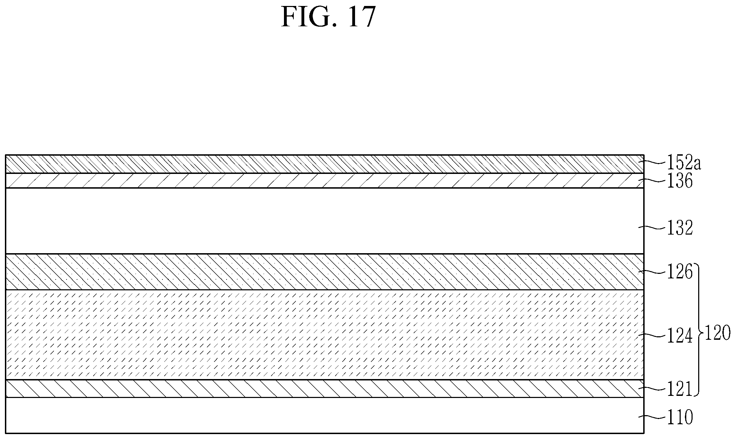

FIGS. 14 and 15 are cross-sectional views showing a process sequence for manufacturing a semiconductor device according to an embodiment. FIG. 16 is an enlarged cross-sectional view of region A2 of FIG. 15. FIGS. 17 to 22 are cross-sectional views showing the process sequence for manufacturing a semiconductor device according to an embodiment.

As shown in FIG. 14, the seed layer 121 and the superlattice layer 124 may be sequentially formed on the substrate 110.

The substrate 110 may include a semiconductor material. For example, the substrate 110 may include sapphire, Si, SiC, AlN, GaN, or a combination thereof. The substrate 110 may be a silicon on insulator (SOI) substrate. However, the material of the substrate 110 is not limited thereto, and any commonly used substrate may be applied.

The seed layer 121 and the superlattice layer 124 may be formed sequentially using an epitaxial growth method. The seed layer 121 may be first formed on the substrate 110, and the sixth region AR6, the fourth region AR4, and the fifth region AR5 of the superlattice layer 124 may be sequentially formed on the seed layer 121.

The seed layer 121 and the superlattice layer 124 may be made of the same semiconductor material. However, considering the role of each layer and the performance required for the semiconductor device, the material composition ratio of each layer may be different. The seed layer 121 and the superlattice layer 124 may include one or more materials selected from group III-V materials, for example, nitrides containing Al, Ga, In, B, or a combination thereof. The seed layer 121 and the superlattice layer 124 may be AlₓIn_{y}Ga_{1-x-y}N (0≤x≤1, 0≤y≤1, x+y≤1). For example, the seed layer 121 and the superlattice layer 124 may include AlN, GaN, InN, InGaN, AlGaN, AlInN, AlInGaN, or a combination thereof.

In an embodiment, the superlattice layer 124 may be made of multiple layers in which layers containing different materials are alternately stacked. For example, the superlattice layer 124 may have a structure in which a layer made of AlGaN and a layer made of AlN are repeatedly stacked. That is, AlGaN/AlN/AlGaN/AlN/AlGaN/AlN may be sequentially stacked to form the superlattice layer 124.

In such case, the first material and the second material may be doped in the sixth region AR6, fourth region AR4, and fifth region AR5 of the superlattice layer 124. The process of doping the first material and the second material into the superlattice layer 124 may be performed using a source gas G1 containing impurities to be doped into the superlattice layer 124. Specifically, the substrate 110 may be prepared in a chamber, and the seed layer 121 may be formed on the substrate 110. Subsequently, in the process of forming the superlattice layer 124 on the seed layer 121, the source gas G1 may be injected into the chamber. The source gas G1 may include a second material. For example, the source gas G1 may include magnesium (Mg), iron (Fe), or a combination thereof. However, embodiments of the present disclosure are not limited thereto, and the source gas G1 may include a first material. For example, the source gas G1 may include carbon C. Meanwhile, when the source gas G1 is injected into the chamber, the second material contained in the source gas G1 may be deposited in the chamber. Therefore, even if the source gas G1 is injected into the chamber in the process of forming the sixth region AR6 of the superlattice layer 124, a relatively small concentration of the second material may be doped into the sixth region AR6. Subsequently, in the process of forming the fourth region AR4, a gradually higher concentration of the second material may be doped. Additionally, in the process of forming the fifth region AR5 by saturating the second material in the chamber, a certain concentration of the second material may be doped into the fifth region AR5. Accordingly, the superlattice layer 124 having a change in concentration of the second material may be formed in the fourth to sixth regions AR4 to AR6 of the superlattice layer 124 according to an embodiment.

In an embodiment, the sum of the concentration of the first material and the concentration of the second material doped in the fourth to sixth regions AR4 to AR6 of the superlattice layer 124 may be constant. For example, the sum of the concentration of the first material and the concentration of the second material doped in the fourth to sixth regions AR4 to AR6 of the superlattice layer 124 may be about 10¹⁷cm⁻³ to about 10²¹cm⁻³.

As shown in FIGS. 15 and 16, the high-resistance layer 126 may be formed on the superlattice layer 124.

Specifically, the third region AR3, the first region AR1, and the second region AR2 of the high-resistance layer 126 may be formed on the fifth region AR5 of the superlattice layer 124.

The high-resistance layer 126 may be made of a low-conductivity material to electrically insulate the substrate 110 and the channel layer 132. The high-resistance layer may include one or more materials selected from group III-V materials, for example, nitrides containing Al, Ga, In, B, or a combination thereof. The high-resistance layer 126 may be AlₓIn_{y}Ga_{1-x-y}N (0≤x≤1, 0≤y≤1, x+y≤1). For example, the high-resistance layer 126 may include AlN, GaN, InN, InGaN, AlGaN, AlInN, AlInGaN, or a combination thereof. The high-resistance layer 126 may be made of a single layer or multiple layers.

In an embodiment, the first material and the second material may be doped in the third region AR3, first region AR1, and second region AR2 of the high-resistance layer 126. The process of doping the first material and the second material into the high-resistance layer 126 may be substantially the same as the process of doping the first material and the second material into the superlattice layer 124. That is, the process of doping the first material and the second material into the high-resistance layer 126 may be performed using the source gas G1 containing the second material. Specifically, the high-resistance layer 126 may sequentially form the third region AR3 where the concentration of the second material as the distance from the lower surface of the high-resistance layer 126 increases, the first region AR1 where the concentration of the second material is constant, and the second region AR2 where the concentration of the second material decreases as the distance from the lower surface of the high-resistance layer 126 increases.

In an embodiment, the sum of the concentrations of the first and second materials doped in the first to third regions AR1 to AR3 of the high-resistance layer 126 may be constant. For example, the sum of the concentration of the first material and the concentration of the second material doped in the first to third regions AR1 to AR3 of the high-resistance layer 126 may be about 10¹⁷cm⁻³ to about 10²¹cm⁻³.

Referring to FIG. 17, the channel layer 132, the barrier layer 136, and a gate semiconductor material layer 152a may be sequentially formed on the high-resistance layer 126.

In an embodiment, the channel layer 132, the barrier layer 136, and the gate semiconductor material layer 152a may be sequentially formed using an epitaxial growth method. For example, the channel layer 132 may be formed on the high-resistance layer 126, the barrier layer 136 may be formed on the channel layer 132, and the gate semiconductor material layer 152a may be formed on the barrier layer 136.

The channel layer 132, the barrier layer 136, and the gate semiconductor material layer 152a may be made of the same semiconductor material. However, considering the role of each layer and the performance required for the semiconductor device, the material composition ratio of each layer may be different. The channel layer 132, barrier layer 136, and gate semiconductor material layer 152a may include one or more materials selected from group III-V materials, for example, nitrides containing Al, Ga, In, B, or a combination thereof. The channel layer 132, the barrier layer 136, and the gate semiconductor material layer 152a may be AlₓIn_{y}Ga_{1-x-y}N (0≤x≤1, 0≤y≤1, x+y≤1). For example, the channel layer 132, barrier layer 136, and gate semiconductor material layer 152a may include AlN, GaN, InN, InGaN, AlGaN, AlInN, AlInGaN, or a combination thereof. The barrier layer 136 may include a material having a different energy band gap than the channel layer 132. The barrier layer 136 may have a higher energy band gap than the channel layer 132. The gate semiconductor material layer 152a may include a material having a different energy band gap than the barrier layer 136.

For example, the substrate 110 may include Si, the seed layer 121 may include AlN, and the superlattice layer 124 may include AlGaN and AlN. The high-resistance layer 126 may include GaN, the channel layer 132 may include GaN, and the barrier layer 136 may include AlGaN. The channel layer 132 and the barrier layer 136 may or may not be doped with impurities. The gate semiconductor material layer 152a may include GaN and may be doped with impurities. The gate semiconductor material layer 152a may be doped with a p-type impurity, for example, magnesium (Mg).

As the lattice structure of Si and GaN are different, it may not be easy to grow the channel layer 132 made of GaN directly on the substrate 110 made of Si. In the method of manufacturing a semiconductor device according to an embodiment, the seed layer 121, the superlattice layer 124, and the high-resistance layer 126 may be first formed on the substrate 110, and then the channel layer 132 may be formed, so that the lattice structure of the channel layer 132 may be stably formed.

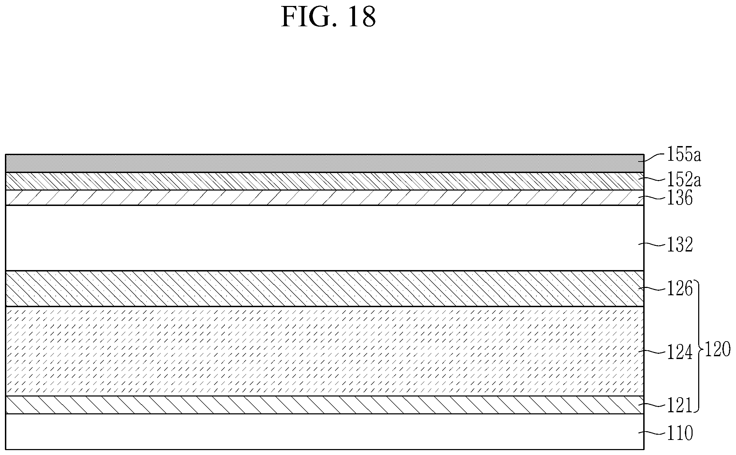

As shown in FIG. 18, a gate electrode material layer 155a may be formed on the gate semiconductor material layer 152a. The gate semiconductor material layer 152a is positioned between the barrier layer 136 and the gate electrode material layer 155a.

The gate electrode material layer 155a may be formed using a deposition process. For example, the gate electrode material layer 155a may be formed by at least one from among electron beam evaporation (E-beam evaporation), sputtering, physical vapor deposition (PVD), thermal chemical vapor deposition (thermal CVD), low pressure chemical vapor deposition (LP-CVD), plasma-enhanced chemical vapor deposition (PE-CVD), and atomic layer deposition (ALD), but is not limited thereto.

The gate electrode material layer 155a may include a conductive material. For example, the gate electrode material layer 155a may include metal, metal alloy, conductive metal nitride, metal silicide, doped semiconductor material, conductive metal oxide, or conductive metal nitride. For example, the gate electrode material layer 155a may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium Carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but it is not limited thereto. The gate electrode material layer 155a may be made of a single layer or multiple layers.

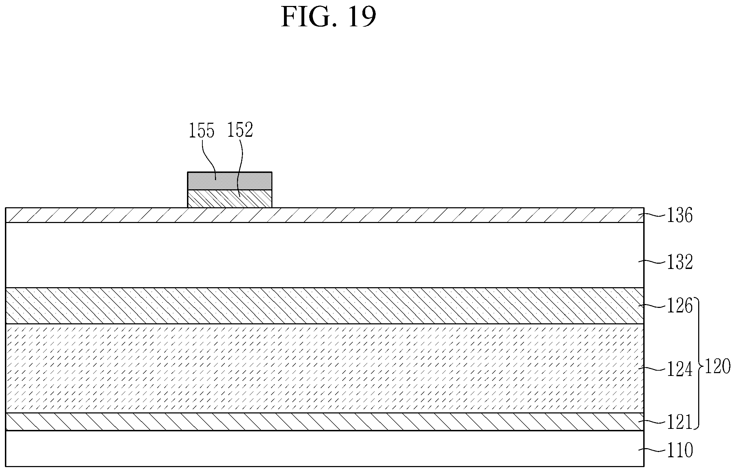

As shown in FIG. 19, the gate electrode 155 and the gate semiconductor layer 152 may be formed by patterning the gate electrode material layer 155a and the gate semiconductor material layer 152a using a photo and etching process.

For example, a hard mask layer and a photoresist layer may be sequentially formed on the gate electrode material layer 155a. A photoresist pattern may be formed by patterning the photoresist layer using a photo process. A hard mask pattern may be formed by etching the hard mask layer using a photoresist pattern as a mask. In such case, in the process of etching the hard mask layer, at least a portion of the gate electrode material layer 155a may be removed. Subsequently, the gate semiconductor material layer 152a is etched using the hard mask pattern as a mask, thereby removing at least a portion of the gate semiconductor material layer 152a. Accordingly, the remaining portion of the gate electrode material layer 155a may become the gate electrode 155. Additionally, the portion of the gate semiconductor material layer 152a that remains may become the gate semiconductor layer 152. The gate semiconductor layer 152 is positioned between the barrier layer 136 and the gate electrode 155. The gate electrode 155 may be in schottky contact or ohmic contact with the gate semiconductor layer 152.

By patterning the gate semiconductor material layer 152a and the gate electrode material layer 155a using the same mask, the gate semiconductor layer 152 and the gate electrode 155 may have the same pattern. That is, the gate semiconductor layer 152 and the gate electrode 155 may have the same planar shape. In a cross-section, the gate semiconductor layer 152 and the gate electrode 155 may have the same width. The gate semiconductor layer 152 may completely overlap with the gate electrode 155 in a vertical direction, and the upper surface of the gate semiconductor layer 152 may be entirely covered by the gate electrode 155, but is not limited thereto. For example, the gate semiconductor layer 152 and the gate electrode 155 may partially overlap in the vertical direction. Also, the gate electrode 155 and the gate semiconductor layer 152 may have different widths. In such case, the gate electrode 155 and the gate semiconductor layer 152 may be patterned using different masks. For example, the gate electrode 155 may be patterned using a photoresist pattern, and the gate semiconductor layer 152 may be patterned using a hard mask pattern.

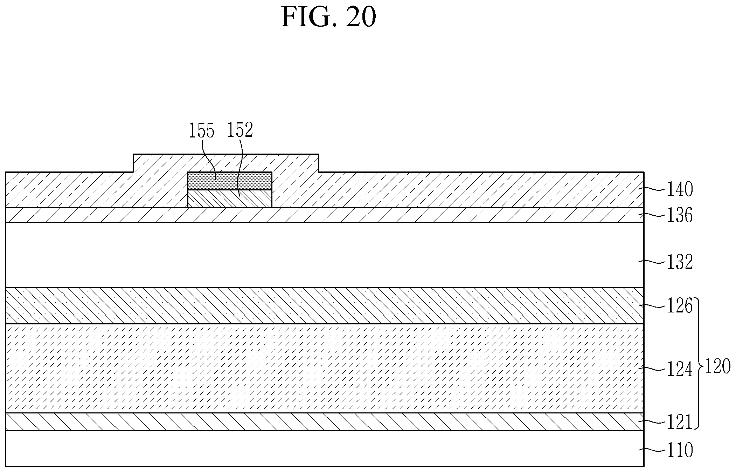

As shown in FIG. 20, the protective layer 140 may be formed on the barrier layer 136 and the gate electrode 155. For example, the protective layer 140 may be formed to cover the barrier layer 136 and the gate electrode 155. The protective layer 140 may include an insulating material. For example, the protective layer 140 may include an oxide such as SiO₂ or Al₂O₃. As another example, the protective layer 140 may include a nitride such as SiN or an oxynitride such as SiON.

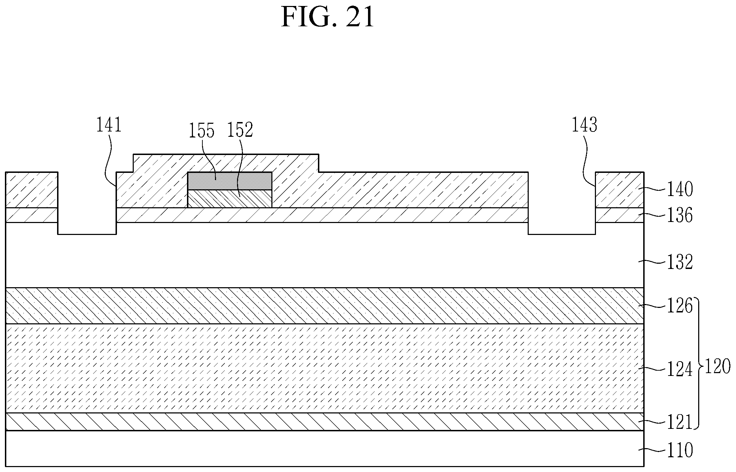

As shown in FIG. 21, a first trench 141 and a second trench 143 may be formed by patterning the protective layer 140 using a photo and etching process. In such case, not only the protective layer 140 but also the barrier layer 136 and the channel layer 132 may be patterned together.

For example, a photoresist pattern may be formed on the protective layer 140 and used as a mask to sequentially etch the protective layer 140, the barrier layer 136, and the channel layer 132. In such case, the protective layer 140 and the barrier layer 136 may be penetrated by the first trench 141 and the second trench 143, and the upper surface of the channel layer 132 may be recessed. The channel layer 132 may not be penetrated by the first trench 141 or the second trench 143. That is, the depth at which the upper surface of the channel layer 132 is recessed may be less than the total thickness of the channel layer 132. In such case, the depth at which the upper surface of the channel layer 132 is recessed may be much less than the total thickness of the channel layer 132. Additionally, the depth at which the upper surface of the channel layer 132 is recessed may be less than the thickness of the barrier layer 136. However, embodiments are not limited thereto, and the depth at which the upper surface of the channel layer 132 is recessed may vary.

The side surfaces of the protective layer 140 and the barrier layer 136 may be exposed to the outside by the first trench 141 and the second trench 143, and the upper and side surfaces of the channel layer 132 may be exposed. The channel layer 132 may form the bottom surface and sidewalls of the first trench 141 and the second trench 143, and the barrier layer 136 may form the sidewalls of the first trench 141 and the second trench 143.

The first trench 141 and the second trench 143 may be spaced apart from each other. The first trench 141 and the second trench 143 may be positioned on respective sides of the gate electrode 155. The first trench 141 may be positioned on one side of the gate electrode 155 to be spaced apart from the gate electrode 155 . The second trench 143 may be positioned on the other side of the gate electrode 155 to be spaced apart from the gate electrode 155. The distance that the first trench 141 is spaced apart from the gate electrode 155 may be less than the distance that the second trench 143 is spaced apart from the gate electrode 155. Although the shapes of the first trench 141 and the second trench 143, including width and depth, are shown to be similar, they are not limited thereto. The shapes of the first trench 141 and the second trench 143 may be changed in various ways.

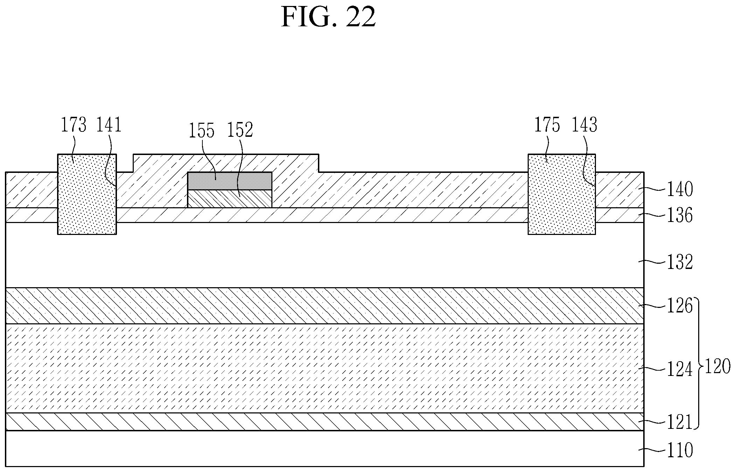

As shown in FIG. 22, a conductive material may be deposited in the first trench 141 and the second trench 143 and patterned to form the source electrode 173 and the drain electrode 175.

The source electrode 173 and the drain electrode 175 may include a conductive material. For example, the source electrode 173 and the drain electrode 175 may include metal, metal alloy, conductive metal nitride, metal silicide, doped semiconductor material, conductive metal oxide, or conductive metal nitride. The source electrode 173 and the drain electrode 175 may be made of a single layer or multiple layers. For example, the source electrode 173 and the drain electrode 175 may be formed by stacking a plurality of conductive layers containing different materials and then patterning them. In such case, the plurality of conductive layers may be etched simultaneously or sequentially using one mask pattern. For example, Ti, Al, Ti, and TiN may be sequentially stacked and then patterned to form the source electrode 173 and the drain electrode 175. In such case, the thickness of the four conductive layers included in the source electrode 173 and the drain electrode 175 may be similar or different. For example, a layer made of Al may be relatively thick compared to other layers.

The source electrode 173 may be formed to fill the interior of the first trench 141. In the first trench 141, the source electrode 173 may contact the channel layer 132 and the barrier layer 136. The source electrode 173 may contact the side surfaces of the channel layer 132 and the barrier layer 136. The source electrode 173 may cover the side surfaces of the channel layer 132 and the barrier layer 136. The source electrode 173 may be electrically connected to the channel layer 132 through the first trench 141. The upper surface of the source electrode 173 may protrude beyond the upper surface of the protective layer 140.

The drain electrode 175 may be formed to fill the interior of the second trench 143. In the second trench 143, the drain electrode 175 may contact the channel layer 132 and the barrier layer 136. The drain electrode 175 may contact the side surfaces of the channel layer 132 and the barrier layer 136. The drain electrode 175 may cover the side surfaces of the channel layer 132 and the barrier layer 136. The drain electrode 175 may be electrically connected to the channel layer 132 through the second trench 143. The upper surface of the drain electrode 175 may protrude beyond the upper surface of the protective layer 140.

The source electrode 173 and the drain electrode 175 may be in ohmic contact with the channel layer 132. The region in contact with the source electrode 173 and the drain electrode 175 in the channel layer 132 may be doped at a relatively high concentration compared to other regions of the channel layer 132. For example, the channel layer 132 may be doped by an ion implant process, an annealing process, etc. However, embodiments are not limited thereto, and the doping process of the channel layer 132 may be performed through various other processes. The doping process of the channel layer 132 may be performed before forming the source electrode 173 and the drain electrode 175. In some cases, the channel layer 132 may not be doped.

Inside the channel layer 132, a two-dimensional electron gas 134 (see FIGS. 1-2) may be formed in a portion adjacent to the barrier layer 136. The two-dimensional electron gas 134 may be positioned at the interface between the channel layer 132 and the barrier layer 136. The two-dimensional electron gas 134 may be positioned in the drift region DTR (see FIGS. 1-2) between the source electrode 173 and the drain electrode 175. The depletion region DPR (see FIG. 1) may be formed in the channel layer 132 by the gate semiconductor layer 152 having a different energy band gap than the barrier layer 136. Accordingly, the semiconductor device according to an embodiment may have normally-off characteristics. That is, the semiconductor device according to an embodiment may be a normally-off high electron mobility transistor (HEMT). In the gate-off state, the two-dimensional electron gas 134 may be positioned in the drift region DTR excluding the depletion region DPR of the channel layer 132. In the gate-on state, the flow of the two-dimensional electron gas 134 continues in the depletion region DPR, and the two-dimensional electron gas 134 may be positioned entirely in the drift region DTR.

In the step of forming the source electrode 173 and the drain electrode 175, a field dispersion layer may be formed together with the source electrode 173 and the drain electrode 175. The field dispersion layer may be positioned between the source electrode 173 and the drain electrode 175. The field dispersion layer may overlap the gate electrode 155. The field dispersion layer may be electrically connected to the source electrode 173. The field dispersion layer may be formed integrally with the source electrode 173. The field dispersion layer may include the same material as a material of the source electrode 173 and may be positioned in the same layer as the source electrode 173.

While non-limiting example embodiments of the present disclosure have been described in detail, it is to be understood that the present disclosure is not limited to the example embodiments. On the contrary, various modifications and equivalent arrangements of embodiments of the present disclosure are included within the scope of the present disclosure.

Aspects of the present disclosure are set out in the following numbered clauses.
1. A semiconductor device, comprising:
   a superlattice layer;
   a high-resistance layer on the superlattice layer and doped with a first material and a second material different from the first material;
   a channel layer on the high-resistance layer;
   a barrier layer on the channel layer and comprising a material having an energy band gap different from an energy band gap of the channel layer;
   a gate electrode on the barrier layer;
   a gate semiconductor layer between the barrier layer and the gate electrode;
   a source electrode on a first side of the gate electrode and connected to the channel layer; and
   a drain electrode on a second side of the gate electrode, opposite of the first side, and connected to the channel layer,
   wherein the high-resistance layer comprises:
      a first region in which a concentration of the second material is constant; and
      a second region, on the first region, in which a concentration of the second material in the second region decreases in a direction away from a lower surface of the high-resistance layer, toward an upper surface of the high-resistance layer.
2. The semiconductor device of clause 1, wherein
   a concentration of the first material doped in the second region increases in the direction away from the lower surface of the high-resistance layer.
3. The semiconductor device of clause 1 or clause 2, wherein
   the concentration of the second material doped in the second region is less than the concentration of the second material doped in the first region.
4. The semiconductor device of clause 3, wherein
   the concentration of the second material doped in the first region is 10¹⁷cm⁻³ to 10²¹cm⁻³.
5. The semiconductor device of any preceding clause, wherein
   a thickness of the second region is 200 nm to 1000 nm.
6. The semiconductor device of any preceding clause, wherein
   the high-resistance layer further comprises a third region, between the first region and the superlattice layer, in which a concentration of the second material in the third region increases in the direction away from the lower surface of the high-resistance layer.
7. The semiconductor device of clause 6, wherein
   a concentration of the first material doped in the third region decreases in the direction away from the lower surface of the high-resistance layer.
8. The semiconductor device of any preceding clause, wherein
   a sum of the concentration of the first material doped in the first region and the concentration of the second material doped in the first region is equal to a sum of the concentration of the first material doped in the second region and the concentration of the second material doped in the second region.
9. The semiconductor device of any preceding clause, wherein
   a sum of the concentration of the first material and the concentration of the second material doped in the high-resistance layer is 10¹⁷cm⁻³ to 10²¹cm⁻³.
10. The semiconductor device of any preceding clause, wherein
   the superlattice layer comprises the first material and the second material.
11. The semiconductor device of clause 10, wherein the superlattice layer comprises:
   a fourth region in which a concentration of the second material increases in a direction away from the lower surface of the superlattice layer, toward an upper surface of the superlattice layer; and
   a fifth region between the first region and the high-resistance layer and having a constant concentration of the second material,
   wherein the concentration of the second material in the fifth region is less than the concentration of the second material in the first region.
12. The semiconductor device wherein of clause 11, wherein
   a thickness of the fourth region of the superlattice layer is 200 nm or more and 2000 nm or less.
13. The semiconductor device of clause 11 or clause 12, wherein
   the concentration of the first material doped in the fourth region decreases in the direction away from the lower surface of the superlattice layer.
14. The semiconductor device of any of clauses 11 to 13, wherein the superlattice layer further comprises a sixth region under the first region and having a concentration of the second material that is constant,
   wherein the concentration of the second material in the sixth region is less than the concentration of the second material in the first region.
15. The semiconductor device of clause 14, wherein
   a thickness of the sixth region of the superlattice layer is 200 nm or more and 500 nm or less.
16. The semiconductor device of any preceding clause, wherein
   the first material comprises carbon, and the second material comprises magnesium or iron.
17. A semiconductor device, comprising:
   a superlattice layer;
   a high-resistance layer on the superlattice layer and doped with a first material and a second material different from the first material;
   a channel layer on the high-resistance layer;
   a barrier layer on the channel layer and comprising a material having an energy band gap different from an energy band gap of the channel layer;
   a gate electrode on the barrier layer;
   a gate semiconductor layer between the barrier layer and the gate electrode;
   a source electrode on a first side of the gate electrode and connected to the channel layer; and
   a drain electrode on a second side of the gate electrode, opposite of the first side, and connected to the channel layer,
   wherein the high-resistance layer comprises:
      a first region in which a concentration of the second material is constant;
      a second region, between the first region and the channel layer, in which a concentration of the second material decreases in a direction away from the lower surface of the high-resistance layer, towards an upper surface of the high-resistance layer; and
      a third region in which a concentration of the second material increases in the direction away from the lower surface of the high-resistance layer, and
   wherein a concentration of the first material doped in the second region increases in the direction away from the lower surface of the high-resistance layer increases.
18. The semiconductor device of clause 17, wherein
   a concentration of the first material doped in the first region is constant.
19. The semiconductor device of clause 17 or clause 18, wherein
   the first material comprises carbon, and the second material comprises magnesium or iron.
20. A semiconductor device, comprising:
   a substrate;
   a superlattice layer on the substrate, the superlattice layer comprises layers comprising AlGaN and layers comprising AlN that are alternately stacked and doped with a first material and a second material different from the first material;
   a high-resistance layer on the superlattice layer and comprising GaN doped with the first material and the second material;
   a channel layer on the high-resistance layer and comprising GaN;
   a barrier layer on the channel layer and comprising AlGaN;
   a gate electrode on the barrier layer and comprising a metal material;
   a gate semiconductor layer between the barrier layer and the gate electrode and comprising GaN doped with a p-type impurity;
   a source electrode on a first side of the gate electrode, and on a first side surface of the channel layer and a first side surface of the barrier layer; and
   a drain electrode on a second side of the gate electrode, opposite of the first side, and on a second side surface of the channel layer and a second side surface of the barrier layer;
   wherein the high-resistance layer comprises:
      a first region in which a concentration of the second material is constant;
      a second region, between the first region and the channel layer, in which a concentration of the second material decreases in a direction away from the lower surface of the high-resistance layer, towards an upper surface of the high-resistance layer; and
      a third region, between the first region and the superlattice layer, in which a concentration of the second material increases in the direction away from the lower surface of the high-resistance layer, and
   wherein the superlattice layer comprises:
      a fourth region in which a concentration of the second material increases in a direction away from a lower surface of the superlattice layer, towards an upper surface of the superlattice layer; and
      a fifth region between the first region and the high-resistance layer and having a constant concentration of the second material.
21. A semiconductor device according to any preceding claim, wherein the first material comprises carbon.
22. A semiconductor device according to any preceding claim, wherein the second material comprises magnesium, iron, or a combination thereof.

## Claims

1. A semiconductor device, comprising:
a superlattice layer;
a high-resistance layer on the superlattice layer and doped with a first material and a second material different from the first material;
a channel layer on the high-resistance layer;
a barrier layer on the channel layer and comprising a material having an energy band gap different from an energy band gap of the channel layer;
a gate electrode on the barrier layer;
a gate semiconductor layer between the barrier layer and the gate electrode;
a source electrode on a first side of the gate electrode and connected to the channel layer; and
a drain electrode on a second side of the gate electrode, opposite of the first side, and connected to the channel layer,
wherein the high-resistance layer comprises:
a first region in which a concentration of the second material is constant; and
a second region, on the first region, in which a concentration of the second material in the second region decreases in a direction away from a lower surface of the high-resistance layer, toward an upper surface of the high-resistance layer.

2. The semiconductor device of claim 1, wherein
a concentration of the first material doped in the second region increases in the direction away from the lower surface of the high-resistance layer.

3. The semiconductor device of claim 1 or claim 2, wherein
the concentration of the second material doped in the second region is less than the concentration of the second material doped in the first region.

4. The semiconductor device of claim 3, wherein
the concentration of the second material doped in the first region is 10¹⁷cm⁻³ to 10²¹cm⁻³.

5. The semiconductor device of any preceding claim, wherein
a thickness of the second region is 200 nm to 1000 nm.

6. The semiconductor device of any preceding claim, wherein
the high-resistance layer further comprises a third region, between the first region and the superlattice layer, in which a concentration of the second material in the third region increases in the direction away from the lower surface of the high-resistance layer.

7. The semiconductor device of claim 6, wherein
a concentration of the first material doped in the third region decreases in the direction away from the lower surface of the high-resistance layer.

8. The semiconductor device of any preceding claim, wherein
a sum of the concentration of the first material doped in the first region and the concentration of the second material doped in the first region is equal to a sum of the concentration of the first material doped in the second region and the concentration of the second material doped in the second region.

9. The semiconductor device of any preceding claim, wherein
a sum of the concentration of the first material and the concentration of the second material doped in the high-resistance layer is 10¹⁷cm⁻³ to 10²¹cm⁻³.

10. The semiconductor device of any preceding claim, wherein
the superlattice layer comprises the first material and the second material.

11. The semiconductor device of claim 10, wherein the superlattice layer comprises:
a fourth region in which a concentration of the second material increases in a direction away from the lower surface of the superlattice layer, toward an upper surface of the superlattice layer; and
a fifth region between the first region and the high-resistance layer and having a constant concentration of the second material,
wherein the concentration of the second material in the fifth region is less than the concentration of the second material in the first region.

12. The semiconductor device wherein of claim 11, wherein
a thickness of the fourth region of the superlattice layer is 200 nm or more and 2000 nm or less.

13. The semiconductor device of claim 11 or claim 12, wherein
the concentration of the first material doped in the fourth region decreases in the direction away from the lower surface of the superlattice layer.

14. The semiconductor device of any of claims 11 to 13, wherein the superlattice layer further comprises a sixth region under the first region and having a concentration of the second material that is constant,
wherein the concentration of the second material in the sixth region is less than the concentration of the second material in the first region.

15. The semiconductor device of claim 14, wherein
a thickness of the sixth region of the superlattice layer is 200 nm or more and 500 nm or less.

## Amended claims

### Amended claims in accordance with Rule 137(2) EPC.

1. A semiconductor device, comprising:
a superlattice layer (124);
a high-resistance layer (126) on the superlattice layer (124) and doped with a first material and a second material different from the first material and wherein both of the first and second materials function as acceptors;
a channel layer (132) on the high-resistance layer (126);
a doped barrier layer (136) on the channel layer (132) and comprising a material having an energy band gap different from an energy band gap of the channel layer (132);
a gate electrode (155) on the barrier layer (136);
a gate semiconductor layer (152) between the barrier layer (136) and the gate electrode (155);
a source electrode (173) on a first side of the gate electrode (155) and connected to the channel layer (132); and
a drain electrode (175) on a second side of the gate electrode (155), opposite of the first side, and connected to the channel layer (132),
wherein the high-resistance layer (126) comprises:
a first region (AR1) in which a concentration of the second material is constant; and
a second region (AR2), on the first region, in which a concentration of the second material in the second region (AR2) decreases in a direction away from a lower surface of the high-resistance layer (126), toward an upper surface of the high-resistance layer.

2. The semiconductor device of claim 1, wherein
a concentration of the first material doped in the second region (AR2) increases in the direction away from the lower surface of the high-resistance layer (126).

3. The semiconductor device of claim 1 or claim 2, wherein
the concentration of the second material doped in the second region (AR2) is less than the concentration of the second material doped in the first region (AR1).

4. The semiconductor device of claim 3, wherein
the concentration of the second material doped in the first region (AR1) is 10¹⁷cm⁻³ to 10²¹cm⁻³.

5. The semiconductor device of any preceding claim, wherein
a thickness of the second region (AR2) is 200 nm to 1000 nm.

6. The semiconductor device of any preceding claim, wherein
the high-resistance layer (126) further comprises a third region (AR3), between the first region (AR1) and the superlattice layer (124), in which a concentration of the second material in the third region (AR3) increases in the direction away from the lower surface of the high-resistance layer (126).

7. The semiconductor device of claim 6, wherein
a concentration of the first material doped in the third region (AR3) decreases in the direction away from the lower surface of the high-resistance layer (126).

8. The semiconductor device of any preceding claim, wherein
a sum of the concentration of the first material doped in the first region (AR1) and the concentration of the second material doped in the first region (AR1) is equal to a sum of the concentration of the first material doped in the second region (AR2) and the concentration of the second material doped in the second region (AR2).

9. The semiconductor device of any preceding claim, wherein
a sum of the concentration of the first material and the concentration of the second material doped in the high-resistance layer (126) is 10¹⁷cm⁻³ to 10²¹cm⁻³.

10. The semiconductor device of any preceding claim, wherein
the superlattice layer (124) comprises the first material and the second material.

11. The semiconductor device of claim 10, wherein the superlattice layer (124) comprises:
a fourth region (AR4) in which a concentration of the second material increases in a direction away from the lower surface of the superlattice layer (124), toward an upper surface of the superlattice layer (124); and
a fifth region (AR5) between the fourth region (AR4) and the high-resistance layer (126) and having a constant concentration of the second material,
wherein the concentration of the second material in the fifth region (AR5) is less than the concentration of the second material in the first region (AR1).

12. The semiconductor device wherein of claim 11, wherein
a thickness of the fourth region (AR4) of the superlattice layer (124) is 200 nm or more and 2000 nm or less.

13. The semiconductor device of claim 11 or claim 12, wherein
the concentration of the first material doped in the fourth region (AR4) decreases in the direction away from the lower surface of the superlattice layer (124).

14. The semiconductor device of any of claims 11 to 13, wherein the superlattice layer (124) further comprises a sixth region (AR6) under the fourth region (AR4) and having a concentration of the second material that is constant,
wherein the concentration of the second material in the sixth region (AR6) is less than the concentration of the second material in the first region (AR1).

15. The semiconductor device of claim 14, wherein
a thickness of the sixth region (AR6) of the superlattice layer (124) is 200 nm or more and 500 nm or less.
